Europäisches Patentamt

(19) European Patent Office

Office européen des brevets

(11) EP 0 961 124 A2

(12) EUROPEAN PATENT APPLICATION

(43) Date of publication:
01.12.1999 Bulletin 1999/48

(51) Int. Cl.$^6$: G01R 21/133

(21) Application number: 99110266.6

(22) Date of filing: 26.05.1999

(84) Designated Contracting States:
AT BE CH CY DE DK ES FI FR GB GR IE IT LI LU
MC NL PT SE
Designated Extension States:
AL LT LV MK RO SI

(30) Priority: 28.05.1998 JP 14715198
31.08.1998 JP 24486898
31.08.1998 JP 24486998
31.08.1998 JP 24489198
27.01.1999 JP 1835699

(71) Applicant:
MATSUSHITA ELECTRIC INDUSTRIAL CO., LTD.
Kadoma-shi, Osaka 571-8501 (JP)

(72) Inventors:
• Kondo, Hiroyuki
Kyoto-shi, Kyoto 615-0061 (JP)
• Fujii, Tomohiro
Neyagawa-shi, Osaka 572-0821 (JP)
• Mishima, Kenshichiro
Ibaraki-shi, Osaka 567-0831 (JP)

(74) Representative:
Kügele, Bernhard et al
NOVAPAT INTERNATIONAL SA,
9, Rue du Valais
1202 Genève (CH)

(54) Multicircuit type instrument and split type current transformer for measuring various electric power quantities

(57)     The multicircuit type instrument of the invention is designed to measure the electric power, electric energy, power factor, reactive power, and reactive energy of one or more voltage lines of alternating-current three-phase electric circuit or alternating-current single-phase electric circuit, and circuits branched off from these voltage lines.

The multicircuit type watt meter of the invention includes at least one line or more of voltage input means of alternating-current three-phase electric circuit or alternating-current single-phase electric circuit, current input means in the same number of voltage input means or more, input switching means for switching over the current input means, an A/D converter converting an analog output of the voltage input means and an analog output of the current input means into digital signals, and a CPU for controlling switching of the input switching means and controlling time shared multiplex sampling of the A/D converter, in which the current input means connected to the input switching means are switched over sequentially by the input switching means between a sampling point and a next sampling point in the basic time shared sampling of time shared multiplex performed by the CPU, and by performing time shared sampling same as the basic time shared sampling in cooperation with each switching, different circuits are sequentially sampled by time sharing, so that the plural electric power values are computed by the CPU from the simultaneous time shared sampling data.

The CPU computes, instead of the electric power, the electric energy, power factor, reactive power and reactive energy, so that the multicircuit type instrument of the invention may be used also as the watthour meter, power factor meter, reactive power meter, or var-hour meter.

FIG.1

EP 0 961 124 A2

**Description**

Background of the Invention

The present invention relates to a multicircuit type instrument for measuring various electric power quantities by receiving voltages from plural lines of alternating-current three-phase circuit or alternating-current single-phase circuit and currents in the same number as the plural lines or more, and a split type current transformer for obtaining such current inputs of the instrument.

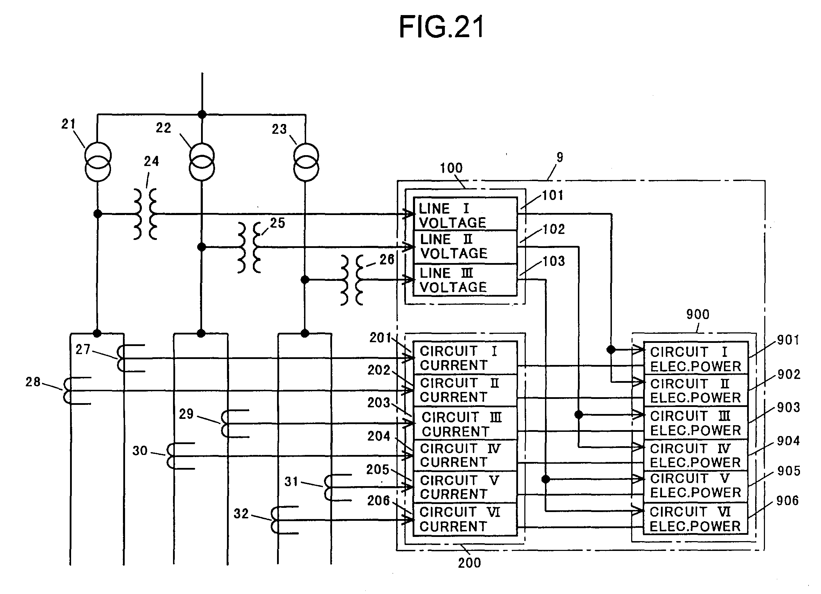

A conventional multicircuit type instrument is explained by referring to Fig. 21. Fig. 21 is a circuit diagram showing a multicircuit type watthour meter in a multicircuit type instrument. In Fig. 21, reference numerals 21, 22 and 23 are step-down transformers which step down from primary voltage to secondary voltage, and 24, 25 and 26 are potential transformers known as PT. Reference numerals 27 to 32 are current transformers for transforming the current value of each circuit into a current value for measurement. This prior art shows a multicircuit type watthour meter designed to measure the power of each circuit from each line voltage and circuit current of thus composed power receiving circuit.

Voltage input means 100 is voltage input means of plural lines, and in the example in Fig. 21 it is the means for receiving voltage from three lines, that is, line I to line III. Current input means 200 is means for receiving currents from the same number of circuits as the voltage inputs or more, and in the example in Fig. 21 it is composed to receive currents from six circuits, that is, circuit I to circuit VI. Power measuring means or energy measuring means 900 is disposed corresponding to the number of current input means so as to measure the power or energy in the same number as the current input means. In the example in Fig. 21, corresponding to circuit I current 201 to circuit VI current 206, it is constituted to measure the power or energy in six circuits from circuit I power measuring section or energy measuring section 901 to circuit VI power measuring section or energy measuring section 906.

On the other hand, each voltage input of plural lines from the voltage input mans 100 is specifically combined with any one of the circuit I power measuring section or energy measuring section 901 to circuit VI power measuring section or energy measuring section 906 provided in the power measuring means or energy measuring means 900.

In the example in Fig. 21, line I voltage 101 is connected to circuit I and circuit II power measuring section or energy measuring section 901 and 902, line II voltage 102 to circuit III and circuit IV power measuring section or energy measuring section 903 and 904, and line III voltage 103 to circuit V and circuit VI power measuring section or energy measuring section 905 and 906. Further, circuit I current 801 to circuit VI current 806 are connected respectively to circuit I power measuring section or energy measuring section 901 to circuit VI power measuring section or energy measuring section 906, and it is designed to measure the power or energy of six circuits. In this prior art, the combination of line voltage and current circuit is always fixed. Since the combination of each voltage input and each current input is fixed in this conventional constitution, as the watt meter or watthour meter, it can be used only in the range of the limited number of current circuits determined in each voltage line.

However, when actually installing these instruments, the number of current lines corresponding to the number of voltage lines is not always fixed, and the number of feeders in each voltage line (the number of branched current circuits) is not always specific, and the number of measuring circuits prepared as watt meters or watthour meters cannot be utilized effectively.

In this prior art, the example of measuring the power or energy is mentioned, but it is the same when measuring other electric power quantities.

Other conventional multicircuit type instrument for computing various electric power quantities from sampling of waveforms of plural input circuits is described by referring to an example disclosed in Japanese Laid-open Patent No. 10-26641.

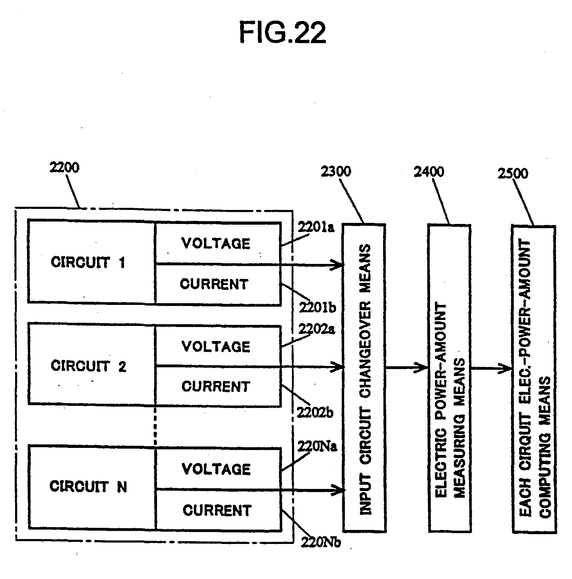

Fig. 22 is a block diagram showing this conventional multicircuit instrument. In Fig. 22, reference numeral 2200 is voltage-current detecting means composed of voltage detecting means 2201a to 220Na and current detecting means 2201b to 220Nb provided in each circuit to be measured (circuit 1 to circuit N), 2300 is input circuit changeover means, 2400 is electric power amount measuring means, and 2500 is each circuit electric power amount computing means.

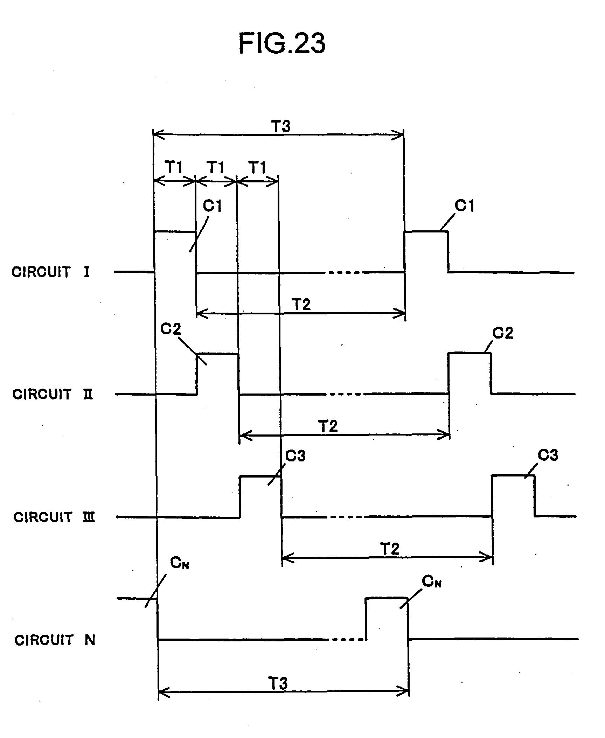

The input circuit changeover means 2300 is to switch plural inputs from the voltage-current detecting means 2200 in each circuit to be measured and issue in electric power amount measuring means. The switching operation of this input circuit changeover means 2300 is shown in Fig. 23. In Fig. 23, the axis of abscissas is the time axis, and it shows the timing of output by the input circuit changeover means 2300 by switching the inputs from the voltage detecting means 2201a to 220Na and current detecting means 2201b to 220Nb in the circuits to be measured (circuit 1 to circuit N), and pulses $C_1$, $C_2$, ... $C_N$ show the period of output of inputs from the voltage detecting means 2201a to 220Na and current detecting means 2201b to 220Nb in circuit 1, circuit 2, ... circuit N by the input circuit changeover means 2300. For example, C1 denotes the period of output of the inputs from the voltage detecting means 2201a and current detecting means 2201b by the input circuit changeover means 2300. Further, T1 is a pulse width corresponding to a selection period (unit time) of selecting each circuit to be measured by the input circuit changeover means 2300, T2 is a selection pause period of each circuit to be measured, and T3 is a repetition period of repeating selection by the input circuit changeover means 2300, which is equivalent to the whole time of selecting all circuits once each.

In this input circuit changeover means 2300, the selection period T1 is set at a specific integer multiple of an alternating-current period, and inputs from the voltage detecting means 2201a to 220Na and current detecting means 2201b to 220Nb in the circuits to be measured 1 to N are sequentially changed over and issued in every period T1 as shown in Fig.23. By using this output, in the electric power amount measuring means 2400, the electric energy in the selection period T1 in each circuit to be measured is measured. Therefore, when measuring N circuits, the required switching period (all circuit selection period) T3 of the input circuit changeover means 2300 is T1 × N times.

Thus, in the electric power amount measuring means 2400, each circuit to be measured is measured for period T1 only, and not measured for period T2. Therefore, the electric power amount measuring means 2400 sends the electric energy for period T1 in each circuit to be measured to the each circuit electric power amount computing means 2500. In the each circuit electric power amount computing means 2500, in each circuit to be measured, the electric energy is regarded the same in both selection pause period T2 and selection period T1, and the electric energy in selection period T1 is multiplied by T3/T1 times, that is, N (the number of circuits to be measured) times, and the product is obtained as the electric energy in switching period T3. In this way, by intermittent measurement of electric energy in each circuit to be measured by the electric power amount measuring means 2400, it is converted into the electric energy by continuous measurement in the each circuit electric power amount computing means 2500.

In this prior art, however, while sampling a specific circuit by switching circuits, there is pause period of sampling in other circuits and there is no particular problem in the circuit of the load having small load fluctuations, but in the circuit having severe load fluctuations, no measurement is made in the pause period, and it is inferior in accuracy, and an error is large in particular when measuring an integrated value, which caused serious problems.

In this prior art, the electric energy is measured, but it is the same when measuring other electric power quantities.

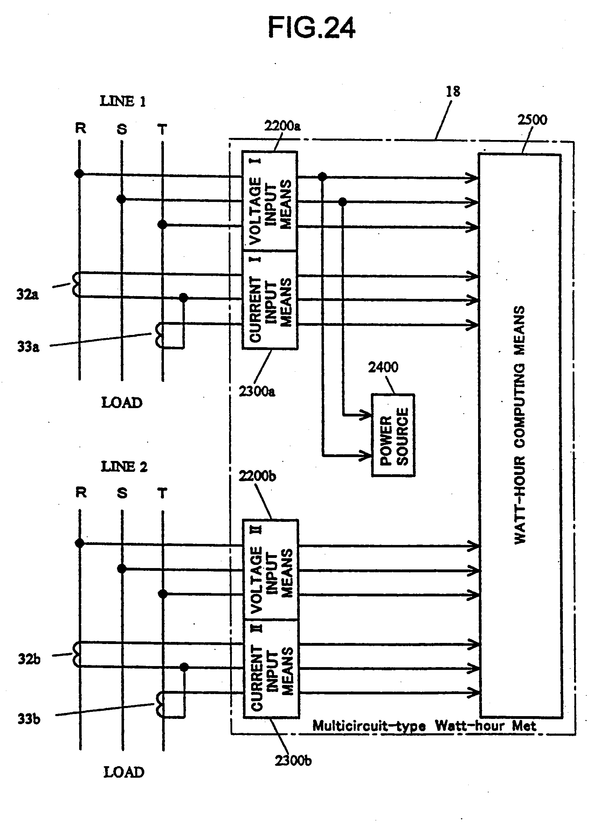

A conventional method of feeding power source to a multicircuit type instrument is explained below by referring to an example in Fig. 24 in which the multicircuit type instrument is a watthour meter. As shown in Fig. 24, this example comprises two lines and two circuits of power circuit, and of phases R, S and T, line voltages between phases R and S and between phases T and S of line 1 are fed into voltage I input means 2200a, and phase currents of phase R and phase T are transformed into currents for measurement by current transformers 32a and 33a, which are fed into current I input means 2300a. Similarly, line voltages between phases R and S and between phases T and S of line 2 are fed into voltage II input means 2200b, and phase currents of phase R and phase T are transformed into currents for measurement by current transformers 32b and 33b, which are fed into current II input means 2300b. Inside a watthour meter 18, an electric power is supplied from the voltage I input means 2200a into a power source section 2400, and it is designed to operate the watthour meter 18 by the electric power supplied into the power source section 2400. From the voltage and current from the voltage I input means 2200a and current I input means 2300a, the electric energy of line I is computed by watthour computing means 2500. Similarly, from the voltage and current from the voltage II input means 2200b and current II input means 2300b, the electric energy of line II is computed by the watthour computing means 2500.

In such conventional plural-circuit type watthour meter, when measuring the electric energy of plural lines and plural circuits, the power source for the watthour meter is supplied from one line only. If the power source supplying line fails to feed power due to power failure or the like, the watthour meter cannot operate at all, and if the other line is provided with voltage, the electric energy of the other line also cannot be measured.

In this prior art, the electric energy is measured, but it is the same when measuring other electric power quantities.

Next is explained a prior art of a split type current transformer used for measurement of electric power quantities of electric power lines.

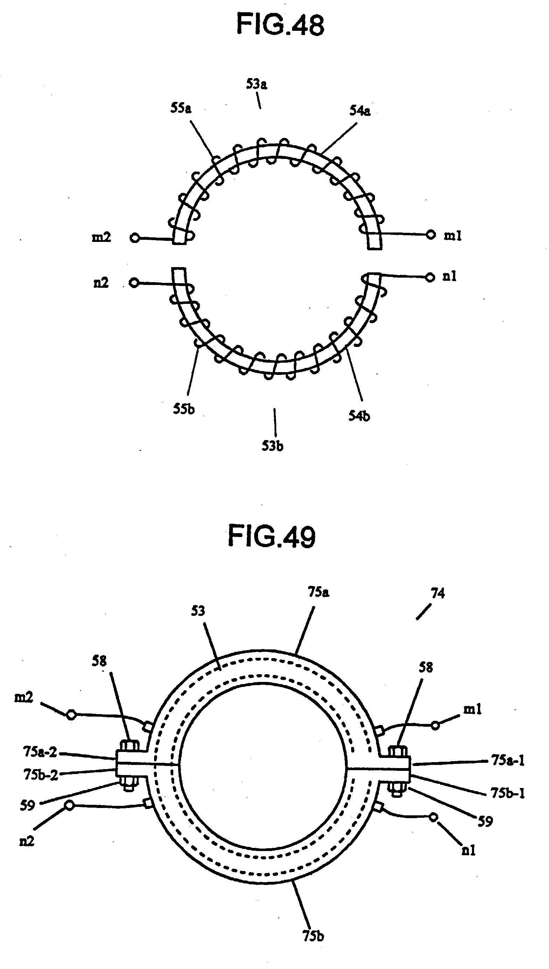

Fig. 48 and Fig. 49 show conventional split type current transformers. Fig. 48 is a diagram showing a magnetic circuit assembly, and the magnetic circuit assembly is divided into 53a and 53b as shown in Fig. 48. The magnetic circuit assembly 53a is composed of a magnetic element 54a and a winding 55a, and the magnetic circuit assembly 53b is composed of a magnetic element 54b and a winding 55b. These magnetic circuit assemblies 53a and 53b are put, in split state, into resin containers as shown in Fig. 49, and assembled as a part 75a and a part 75b. At both ends of the part 75a, tightening pedestals 75a-1 and 75a-2 are provided, and at both ends of the part 75b, tightening pedestals 75b-1 and 75b-2 are provided, The tightening pedestal 75a-1 of the part 75a and the tightening pedestal 75b-1 of the part 75b are disposed to confront each other, and tightening pedestal 75a-2 of the part 75a and the tightening pedestal 75b-2 of the part 75b are disposed to confront each other, and the individual confronting parts are clamped by screws 58 and nuts 59. Moreover, both ends m1 and m2 of the winding 55a wound around the magnetic element 54a sealed in the resin container and both ends n1 and n2 of the winding 55b wound around the magnetic element 54b are drawn outside of the resin containers, and they are connected so that the ends m2 and n2 may be of additional polarity.

The other ends m1 and n1 of these windings are output terminals of this split type current transformer.

In the split type current transformer of this conventional constitution, since the structure of the tightening parts is large in size, it requires a wide space for installation, and it is hard to mount on the wires to be measured in the narrow space in which the wires are densely arranged. Still more, since the current transformer is completely separated into the part 75a and part 75b, particular means was needed for connecting correctly so that the windings drawn out to outside may be of additional polarity securely. It was also necessary to couple the completely separated two parts at two positions, and it was difficult to work in a narrow place of installation.

Summary of the Invention

The invention is intended to solve various problems discussed above and achieve the following objects.

it is an object to utilize effectively the number of measuring circuits prepared for measuring various electric power quantities of multiple circuits if the number of feeders (number of branched current circuits) is not specific in each voltage line.

It is also an object to measure various electric power quantities of multiple circuits always at high precision even in circuits having severe load fluctuations.

It is a further object to measure various electric power quantities of multiple circuits stably, while feeding power source always to the measuring apparatus, if power failure occurs in a specific line out of plural lines or if power failure is repeated in plural lines.

It is a different object to present a split type current transformer capable of mounting on wires to be measured even in a narrow space where multiple wire are densely disposed, high in working efficiency in narrow place of installation, and free from risk of mistaking connection of external drawn-out wires.

The multicircuit type instrument for measuring various electric power quantities of the invention comprises:

voltage input means for receiving voltages of plural lines of an alternating-current circuit,
current input means in the number same as the number of voltage input means or more,
measuring means of various electric power quantities in the same number as the current input means, and
voltage-current arbitrary combination means for relaying voltage input to these measuring means of various electric power quantities,
in which the voltage-current arbitrary combination means can arbitrarily select the combination of each current input means and voltage input means.

In thus constituted multicircuit type instrument for measuring various electric power quantities, since the combination of current input means and voltage input means can be arbitrarily selected, if the number of feeders in each voltage line is not specific, it is easily applicable, and the measuring circuits can be utilized to the maximum extent, so that the apparatus may be lowered in cost and reduced in size.

The multicircuit type instrument for measuring various electric power quantities in other aspect of the invention comprises:

voltage input means of plural lines of an alternating-current circuit,
current input means in the number same as the number of voltage input means or more,
switching means for switching current inputs to these measuring means of various electric power quantities,
an A/D converter for converting analog outputs from the voltage input means and current input means into digital signals, and
a CPU responsible for switching control of current inputs by the switching means and time sharing multiplex sampling control to the A/D converter,
in which the CPU performs sequential time shared sampling while switching the current input means by the switching means, between one sampling point and next sampling point of one current input, and computes various electric power quantities of plural circuits from the sampling data.

In thus constituted multicircuit type measuring apparatus of various electric power quantities, since there is no failure in measurement of data when switching the inputs, electric power quantities can be measured at high precision even in a load circuit large in fluctuations. Moreover, by sampling by time sharing multiplexing, electric power quantities of multiple circuits can be measured by an A/D converter of a smaller number of channels, so that the apparatus may be lowered in cost and reduced in size.

The multicircuit type instrument for measuring various electric power quantities in a different aspect of the invention comprises:

voltage input means of plural lines of an alternating-current circuit,
current input means in the number same as the number of voltage input means or more,
power source switching means for selecting automatically a line containing voltage out of plural lines entered from the voltage input means,
a power source section for feeding electric power to the multicircuit type measuring circuit of various electric quantities by using the line selected by the power source switching means as the power source, and

measuring means for measuring various electric power quantities from the output data from the voltage input means and output data from the current input means.

In thus constituted multicircuit type measuring instrument of various electric power quantities, if power failure occurs in the line feeding electric power to the measuring instrument, it is changed over to the remaining lines having voltage to supply electric power to the measuring instrument from the line having voltage, so that measurement of various electric power quantities in the other lines than the power failure line can be continuous without interruption.

The split type current transformer of the invention comprises:

a magnetic circuit assembly having one magnetic element for composing a closed magnetic circuit into two sections, applying winding on each one of the divided two magnetic elements according to the rating of the current transformer, connecting one end of the two windings to the additional polarity, and using other end of the two windings as secondary output terminal of the current transformer, a nonmagnetic container enclosing the magnetic circuit assembly in the whole circumference, having an opening near the divided end of the magnetic element closer to the secondary output terminal, and deforming at the remotest position from the opening to form a fulcrum, and a band-like fixing element for fixing the two divided magnetic circuit assemblies by tightening the outer circumference of the nonmagnetic container, in which the band-like fixing element is designed to open at a position near the output end of the two windings.

In thus constituted split type current transformer, since the connecting position of the band-like fixing element is one position and is formed in a small size, and hence it is possible to mount on the wires to be measured even in a narrow space in which wires are densely disposed, and the working efficiency in a narrow place of installation is enhanced. Still more, since one end of the winding connected to the additional polarity is always connected, it is free from risk of connection in wrong polarity when installing the current transformer.

Brief Description of the Drawings

Fig. 1 is a circuit diagram showing a multicircuit type watt meter employing the voltage-current arbitrary combination means.
Fig. 2 is a circuit diagram showing a specific example of the voltage-current arbitrary combination means in the multicircuit type watt meter in Fig. 1.
Fig. 3 is a circuit diagram showing a multicircuit type watthour meter employing the voltage-current arbitrary combination means.
Fig. 4 is a circuit diagram showing a specific example of the voltage-current arbitrary combination means in the multicircuit type watthour meter in Fig. 3.
Fig. 5 is a circuit diagram showing a multicircuit type watt meter employing second means in voltage-current arbitrary combining.
Fig. 6 is a circuit diagram showing a multicircuit type watthour meter employing second means in voltage-current arbitrary combining.
Fig. 7 is a circuit diagram showing a multicircuit type watt meter employing third means in voltage-current arbitrary combining.
Fig. 8 is a circuit diagram showing an electric power computing unit in the multicircuit type watt meter employing third means in voltage-current arbitrary combining.
Fig. 9 is a circuit diagram showing a multicircuit type watthour meter employing third means in voltage-current arbitrary combining.
Fig. 10 is a circuit diagram showing an electric energy computing unit in the multicircuit type watthour meter employing third means in voltage-current arbitrary combining.
Fig. 11 is an input timing diagram of voltage and current in the multicircuit type watt meter shown in Fig. 5 or the multicircuit type watthour meter shown in Fig. 6.
Fig. 12 is an input timing diagram of voltage and current in the multicircuit type watt meter shown in Fig. 2 or the multicircuit type watthour meter shown in Fig. 3.
Fig. 13 is a circuit diagram of a multicircuit type watt meter having current input switching means for performing time shared multiplex sampling.
Fig. 14A is a waveform diagram showing sampling points of time shared multiplex sampling of voltage corresponding to two voltage lines.
Fig. 14B is a waveform diagram showing sampling points of time shared multiplex sampling of current corresponding to two voltage lines.
Fig. 15 is a circuit diagram of a multicircuit type watt meter having current input switching means and voltage input switching means for performing time shared multiplex sampling.
Fig. 16 is a circuit diagram of other embodiment of multicircuit type watt meter having current input switching means for performing time shared multiplex sampling.
Fig. 17 is a circuit diagram of a different embodiment of multicircuit type watt meter having current input switching means and voltage input switching means for performing time shared multiplex sampling.

Fig. 18 is a circuit diagram of a multicircuit type watthour meter for feeding power source of watthour meter from plural voltage lines.

Fig. 19 is a circuit diagram of a multicircuit type watthour meter having priority order selecting means for feeding power source of watthour meter from plural voltage lines.

Fig. 20 is a circuit diagram of a multicircuit type watthour meter having priority order selecting means for feeding power source of watthour meter from plural voltage lines, in the case of input of three voltage lines.

Fig. 21 is a circuit diagram showing an example of conventional multicircuit type watt meter or multicircuit type watthour meter.

Fig. 22 is a circuit diagram showing other example of conventional multicircuit type watt meter or multicircuit type watthour meter.

Fig. 23 is an explanatory diagram of switching action of input switching circuit in the conventional multicircuit type watt meter or multicircuit type watthour meter shown in Fig. 22.

Fig. 24 is a circuit diagram showing a different example of conventional multicircuit type watt meter or multicircuit type watthour meter.

Fig. 25 is a diagram showing a mounted state of a split type current transformer of the invention on a wire to be measured.

Fig. 26 is a diagram showing a magnetic circuit assembly used in the split type current transformer of the invention.

Fig. 27 is a sectional view of a magnetic element used in the split type current transformer of the invention.

Fig. 28 is a diagram showing a nonmagnetic container used in the split type current transformer of the invention.

Fig. 29 is a sectional view of a nonmagnetic container used in the split type current transformer of the invention.

Fig. 30 is a diagram showing a sealed state of a magnetic circuit assembly in a nonmagnetic container of the split type current transformer of the invention.

Fig. 31 is a sectional view showing a sealed state of a magnetic circuit assembly in a nonmagnetic container of the split type current transformer of the invention.

Fig. 32 is a diagram showing an opened state of a junction for mounting the split type current transformer of the invention on a wire.

Fig. 33 is a diagram showing a state of mounting of the split type current transformer of the invention on plural wires to be measured disposed at narrow intervals.

Fig. 34 is a diagram showing an embodiment in which a cut is opened in a fulcrum of a nonmagnetic container used in the split type current transformer of the invention.

Fig. 35 is a detailed diagram near the fulcrum of the nonmagnetic container shown in Fig. 34.

Fig. 36 is a structural diagram of butt joint of a separated nonmagnetic container in other embodiment of a split type current transformer of the invention.

Fig. 37 is other structural diagram of fulcrum of a nonmagnetic container of the split type current transformer of the invention.

Fig. 38 is an entire structural diagram in a different embodiment of a split type current transformer of the invention.

Fig. 39 is a partial sectional view of the split type current transformer shown in Fig. 38.

Fig. 40 is a partial sectional view of other position of the split type current transformer shown in Fig. 38.

Fig. 41 is a detailed view of the fulcrum portion of the split type current transformer shown in Fig. 38.

Fig. 42 is a partial sectional view of a further different position of the split type current transformer shown in Fig. 38.

Fig. 43 is a diagram for explaining deviation of the magnetic elements at the butt joint of the magnetic elements.

Fig. 44 is a diagram for explaining inclination of the magnetic elements at the butt joint of the magnetic elements.

Fig. 45 is a diagram showing injection state of an elastic filler into the split type current transformer shown in Fig. 42.

Fig. 46 is a structural diagram of fulcrum of a further different embodiment of a split type current transformer of the invention.

Fig. 47 is a general structural diagram of the split type current transformer having the fulcrum shown in Fig. 46.

Fig. 48 is a diagram showing a magnetic circuit assembly of a conventional split type current transformer.

Fig. 49 is an appearance structural diagram of a conventional split type current transformer.

Description of the Preferred Embodiments

(Embodiment 1)

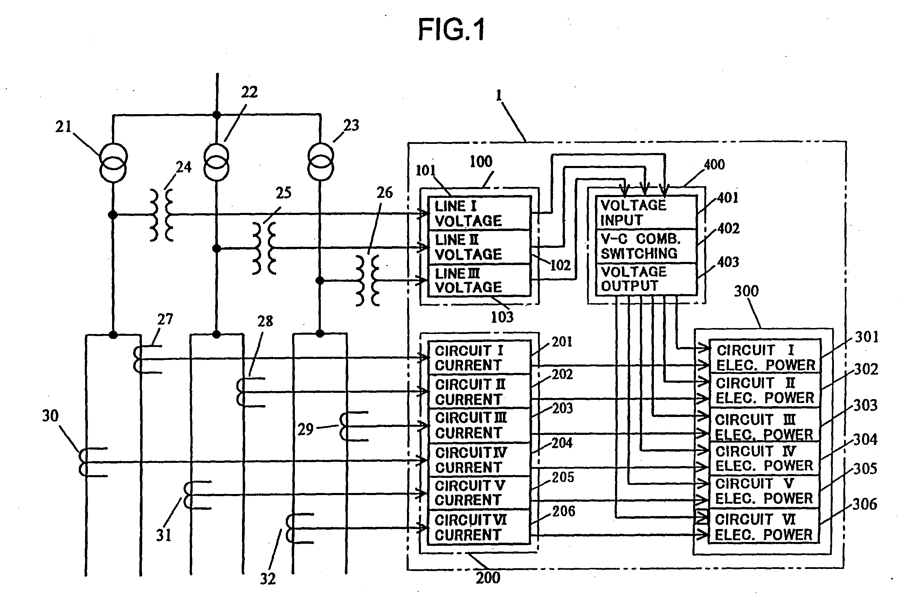

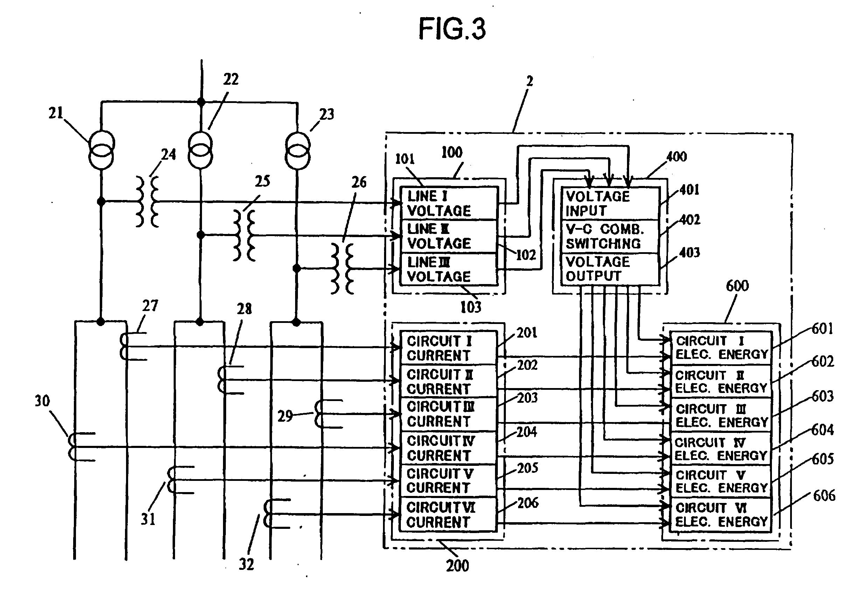

Referring first to Fig. 1 and Fig. 3, this is to explain a multicircuit type measuring instruments of various electric power quantities capable of effectively utilizing the number of measuring circuits if the number of feeders (number of branched current circuits) in each voltage line is not specific. In Fig. 1, the multicircuit type measuring instrument is a watt meter, and Fig. 3 shows that the multicircuit type measuring instrument is a watthour meter

In Fig. 1, reference numerals 21, 22 and 23 are step-down transformers which step down from primary voltage to secondary voltage, and 24, 25 and 26 are potential transformers known as PT. Reference numerals 27 to 32 are current transformers for transforming the current value of each circuit into a current value for measurement. This embodiment relates to a multicircuit type watt meter designed to measure the electric power of each circuit from each line voltage and circuit current of thus composed electric power circuit.

In Fig. 1, reference numeral 1 enclosed by double dot chain line shows the multicircuit type watt meter of the first embodiment. The multicircuit type watt meter 1 comprises voltage input means 100, current input means 200, power measuring means 300, and voltage-current combining means 400. The voltage input means 100 is designed to correspond to voltage inputs from three lines of line I voltage 101 to line III voltage 103, and the current input means 200 is designed to correspond to current inputs from six circuits of circuit I current 201 to circuit VI current 206. The power measuring means 300 is composed of power measuring sections 301 to 306 in the same number as the number of current inputs of the current input means 200.

The voltage-current combining means 400 receives voltages from plural lines of the voltage input means 101 to 103, and arbitrarily selects and separates these voltages and delivers to power measuring sections 301 to 306. The voltage-current, combining means 400 is composed of a voltage input section 401 for receiving voltages from plural lines of the voltage input means 100, a voltage-current combination switching section 402 for arbitrarily selecting combination of line voltages 101 to 103 and circuit current inputs 201 to 206 of the current input means 200, and a voltage output section 403 for delivering the selected individual voltages to any one of the power measuring sections 301 to 306.

In the power measuring sections 301 to 306 of the power measuring means 300, the circuit currents 201 to 206 are connected, and therefore by arbitrarily selecting the line voltages 101 to 103 by the voltage-current combining means 400 and delivering to the power measuring sections 301 to 306, the electric power can be measured by arbitrarily combining the line voltages 101 to 103 and circuit currents 201 to 206.

For example, circuit I power measuring section 301 and circuit II power measuring section 302 can be combined with line I voltage 101, circuit III power measuring section 303 and circuit IV power measuring section 304 with line II voltage 102, and circuit V power measuring section 305 and circuit VI power measuring section 306 with line III voltage 103. Alternatively, for example, circuit I power measuring section 301 can be combined with line I voltage 101, circuit II power measuring section 302 to circuit V power measuring section 305 with line II voltage 102, and circuit VI power measuring section 306 with line III voltage 103.

Thus, by arbitrary combination of power measuring sections and line voltages, the electric power can be measured, and if the number of feeders differs in each voltage line, the installed circuits for power measurement can be utilized to the full extent.

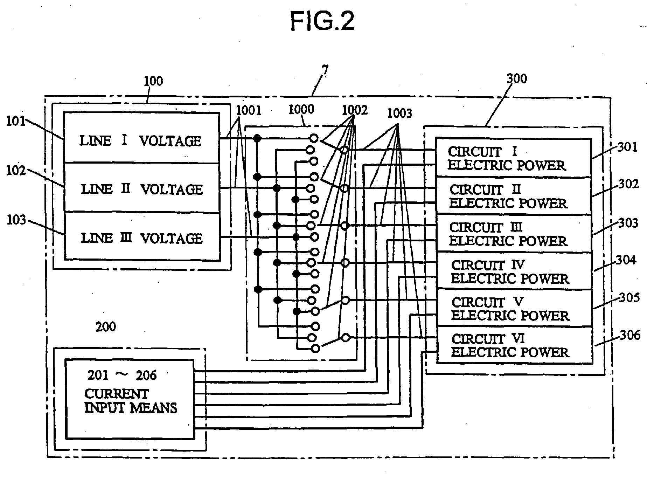

Fig. 2 is an example of specific structure of the voltage-current combining means 400 in the multicircuit type watt meter shown in Fig. 1.

In Fig. 2, reference numeral 7 enclosed by double dot chain line is the multicircuit type watt meter. Voltage-current combining means 1000 is composed of a three-line voltage input section 1001 for receiving line I voltage 101 to line III voltage 103 of the voltage input means 100, a changeover switch 1002 for selecting and delivering only one of these voltage inputs, and a voltage output section 1003 for delivering the selected voltage output to circuit I power measuring section 301 to circuit VI power measuring section 306 of the power measuring means 300. The voltage output sections 1003 are provided as many as the number of circuit I power measuring section 301 to circuit VI power measuring section 306, and the line I voltage 101 to line III voltage 103 are selected by switching the changeover switch 1002, so that a desired line voltage is put into a desired power measuring section. Therefore, according to this constitution, the electric power can be measured by an arbitrary combination of and line voltages and circuit currents.

(Embodiment 2)

In the case the multicircuit type measuring instrument is a watthour meter, it is explained in Fig. 3. In Fig. 3, reference numeral 2 enclosed by double dot chain line denotes a multicircuit type watthour meter. The multicircuit type watthour meter 2 comprises voltage input means 100, current input means 200, voltage-current combining means 400, and electric energy measuring means 600. The voltage input means 100 is designed to correspond to voltage inputs from three lines of line I voltage 101 to line III voltage 103, and the current input means 200 is designed to correspond to current inputs from six circuits of circuit I current 201 to circuit VI current 206. The electric energy measuring means 600 is composed of electric energy measuring sections 601 to 606 in the same number as the number of current inputs of the current input means 200.

The voltage-current combining means 400 receives voltages from plural lines of the voltage input means 100, and arbitrarily selects and separates these voltages and delivers to electric energy measuring sections 601 to 606. The voltage-current combining means 400 is composed of a voltage input section 401 for receiving voltages from plural lines of the voltage input means 100, a voltage-current combination switching section 402 for arbitrarily selecting combination of line voltages 101 to 103 and circuit current inputs 201 to 206 of the current input means 200, and a voltage output section 403 for delivering the selected individual voltages to any one of the electric energy measuring sections 601 to 606.

In the electric energy measuring sections 601 to 606 of the electric energy measuring means 600, the circuit currents 201 to 206 are connected, and therefore by arbitrarily selecting the line voltages 101 to 103 by the voltage-current combining means 400 and delivering to the electric energy measuring sections 601 to 606, the electric energy can be measured by arbitrarily combining the line voltages 101 to 103 and circuit currents 201 to 206.

For example, circuit I electric energy measuring section 601 and circuit II electric energy measuring section 602 can be combined with line I voltage 101, circuit III electric energy measuring section 603 and circuit IV electric energy measuring section 604 with line II voltage 102, and circuit V electric energy measuring section 605 and circuit VI electric energy measuring section 606 with line III voltage 103. Alternatively, for example, circuit I electric energy measuring section 601 can be combined with line I voltage 101, circuit II electric energy measuring section 602 to circuit V electric energy measuring section 605 with line II voltage 102, and circuit VI electric energy measuring section 606 with line III voltage 103.

Thus, by arbitrary combination of electric energy measuring sections and line voltages, the electric energy can be measured, and if the number of feeders differs in each voltage line, the installed circuits for electric energy measurement can be utilized to the full extent.

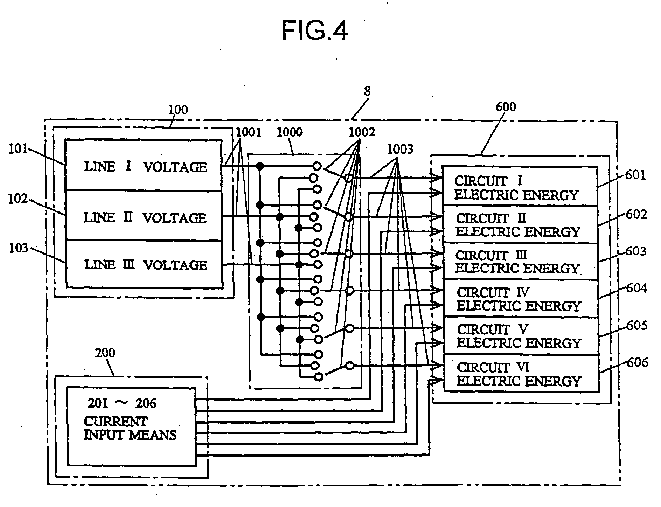

Fig. 4 is an example of specific structure of the voltage-current combining means 400 in the multicircuit type watthour meter shown in Fig. 3.

In Fig. 4, reference numeral 8 enclosed by double dot chain line is the multicircuit type watthour meter. Voltage-current combining means 1000 is composed of a three-line voltage input section 1001 for receiving line I voltage 101 to line III voltage 103 of the voltage input means 100, a changeover switch 1002 for selecting and delivering only one of these voltage inputs, and a voltage output section 1003 for delivering the selected voltage output to circuit I electric energy measuring section 601 to circuit VI electric energy measuring section 606 of the electric energy measuring means 600. The voltage output sections 1003 are provided as many as the number of circuit I electric energy measuring section 601 to circuit VI electric energy measuring section 606, and the line I voltage 101 to line III voltage 103 are selected by switching the changeover switch 1002, so that a desired line voltage is put into a desired electric energy measuring section. Therefore, according to this constitution, the electric energy can be measured by an arbitrary combination of circuit currents and line voltages. Hence, if the number of feeders differs in each voltage line, the installed circuits for electric energy measurement can be utilized to the full extent.

(Embodiment 3)

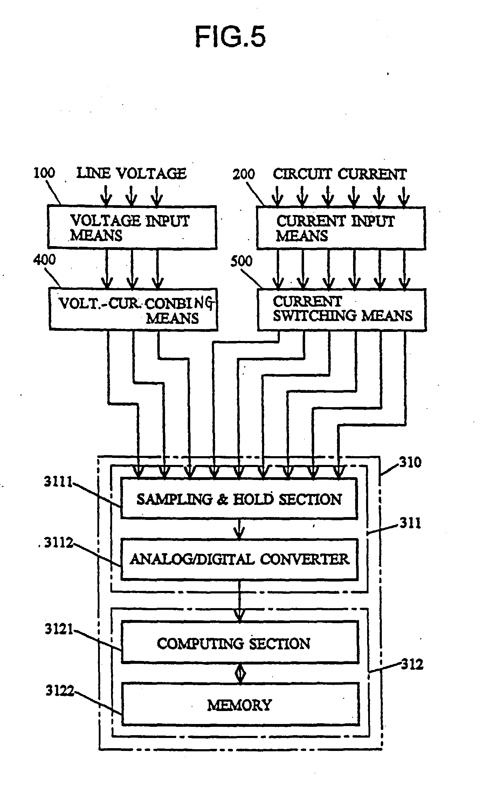

Fig. 5 shows other specific structure of a multicircuit type watt meter. In Fig. 5, reference numeral 310 denotes power measuring means, which samples momentary values of voltage and current simultaneously, and computes the product of momentary values of voltage and current, the sum of products in one sampling period, and the electric power by the average of the sums in one sampling period. The multicircuit type watt meter shown in Fig. 5 comprises voltage input means 100, current input means 200, current switching means 500, voltage-current combining means 400, and power measuring means 310, The power measuring means 310 comprises time shared measuring means 311 composed of a sampling & hold section 3111 and an A/D converter 3112, and a power computing section 312 composed of a computing section 3121 and a memory 3122.

In the power measuring means 310 in Fig. 5, the voltage and current are shared in time over one cycle of alternating current period by the sampling & hold section 3111, and the voltage and current shared in time are sampled and temporarily held, and the temporarily held sampling data is converted into digital data by the A/D converter 3112. In the power computing section 312, the product of time shared measured data of voltage and current is computed, the sum of the products in one sampling period is computed, and further the average is determined to compute the electric power amount.

The voltage input means 100, current input means 200, current switching means 500, and voltage-current combining means 400 for composing the front stage of the power measuring means 310 are described below.

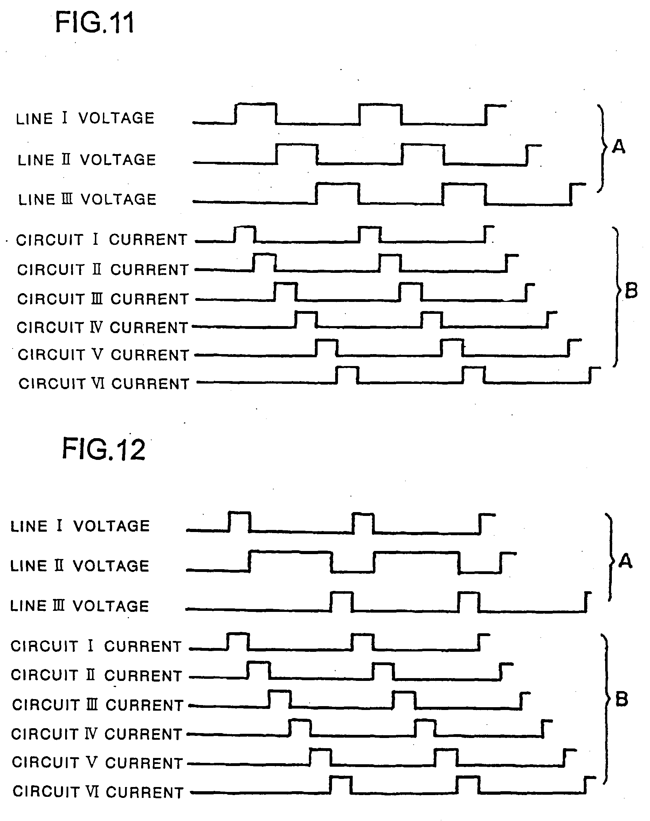

The voltage input means 100 and current input means 200 have the same function as shown in Fig. 1 and Fig. 3. The current switching means 500 is provided in order to switch the current of each circuit entered through the current input means 200 sequentially at the timing shown in Fig. 11 or Fig. 12.

The voltage-current combining means 400 is provided in the front stage of the power measuring means 310, and in the example in Fig. 5 it is placed between the voltage input means 100 and power measuring means 310. This voltage-current combining means 400 is, as shown in Fig. 11 and Fig. 12, designed to determine to deliver an output by synchronizing which line voltage with which circuit current. In Fig. 11, circuit I current and circuit II current are synchronized with line I voltage, circuit III current and circuit IV current with line II voltage, and circuit V current and circuit VI current with line III voltage. On the other hand, in the example in Fig. 12, circuit I current is synchronized with line I voltage, circuit II current, circuit III current, circuit IV current and circuit V current with line II voltage, and circuit VI current with line III voltage.

Thus, the electric power amount is determined by synchronizing the sampling period of voltage and current, and by the voltage-current combining means 400, as shown in Fig. 11 and Fig. 12, the line voltage can be arbitrarily selected and combined with the circuit current. Therefore, the electric power corresponding to each circuit current can be determined by any line voltage.

Incidentally, the above definition of simultaneous sampling is not limited alone to the simultaneous sampling by plural sampling & hold circuits, but also includes a method of measuring at high speed by the A/D converter by sequentially switching the objects of measurement by a multiplexer or the like, using only one sampling & hold circuit. The same definition is applied to the simultaneous sampling explained in the following embodiments.

According to the embodiment described herein, by setting parts such as switching means, the line voltage can be selected by the hardware. Thus, by arbitrary combination of circuit currents and line voltages, the electric power can be measured, and hence, if the number of feeders differs in each voltage line, the installed circuits for power measurement can be utilized to the full extent.

(Embodiment 4)

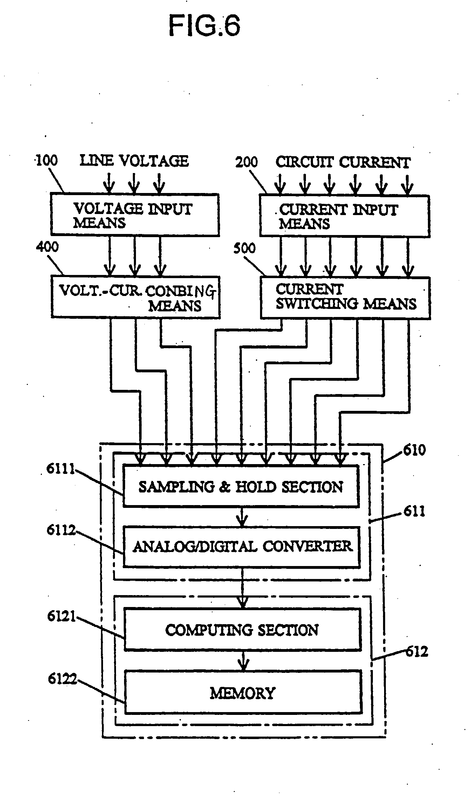

Fig. 6 shows other specific structure of a multicircuit type watthour meter. In Fig. 6, reference numeral 610 denotes electric energy measuring means, which samples momentary values of voltage and current simultaneously, and computes the product of momentary values of voltage and current, the sum of products in one sampling period, and the electric energy by integrating the sum of products. The multicircuit type watthour meter shown in Fig. 6 comprises voltage input means 100, current input means 200, current switching means 500, voltage-current combining means 400, and electric energy measuring means 610. The electric energy measuring means 610 comprises time shared measuring means 611 composed of a sampling & hold section 6111 and an A/D converter 6112, and an electric energy computing section 612 composed of a computing section 6121 and a memory 6122.

In the electric energy measuring means 610 in Fig. 6, the voltage and current are shared in time over one cycle of alternating current period by the sampling & hold section 6111, and the voltage and current shared in time are sampled and temporarily held, and the temporarily held sampling data is converted into digital data by the A/D converter 6112. In the electric energy computing section 612, the product of time shared measured data of voltage and current is computed, the sum of the products in one sampling period is computed, and further the integrated value of the sum of products is determined to compute the electric energy amount.

The voltage input means 100, current input means 200, current switching means 500, and voltage-current combining means 400 for composing the front stage of the electric energy measuring means 610 are described below.

The voltage input means 100 and current input means 200 have the same function as shown in Fig. 3. The current switching means 500 is provided in order to switch the current of each circuit entered through the current input means 200 sequentially at the timing shown in Fig. 11 or Fig. 12.

The voltage-current combining means 400 is provided in the front stage of the electric energy measuring means 610, and in the example in Fig. 6 it is placed between the voltage input means 100 and electric energy measuring means 610. This voltage-current combining means 400 is, as shown in Fig. 11 and Fig. 12, designed to determine to deliver an output by synchronizing which line voltage with which circuit current. In Fig. 11, circuit I current and circuit II current are synchronized with line I voltage, circuit III current and circuit IV current with line II voltage, and circuit V current and circuit VI current with line III voltage. On the other hand, in the example in Fig. 12, circuit I current is synchronized with line I voltage, circuit II current, circuit III current, circuit IV current and circuit V current with line II voltage, and circuit VI current with line III voltage.

Thus, the electric energy amount is determined by synchronizing the sampling period of voltage and current, and by the voltage-current combining means 400, as shown in Fig. 11 and Fig. 12, the line voltage can be arbitrarily selected and combined with the circuit current. Therefore, the electric energy corresponding to each circuit current can be determined by any line voltage.

According to the embodiment described herein, by setting parts such as switching means, the line voltage can be selected by the hardware. Thus, by arbitrary combination of circuit currents and line voltages, the electric energy can be measured, and hence, if the number of feeders differs in each voltage line, the installed circuits for electric energy measurement can be utilized to the full extent.

(Embodiment 5)

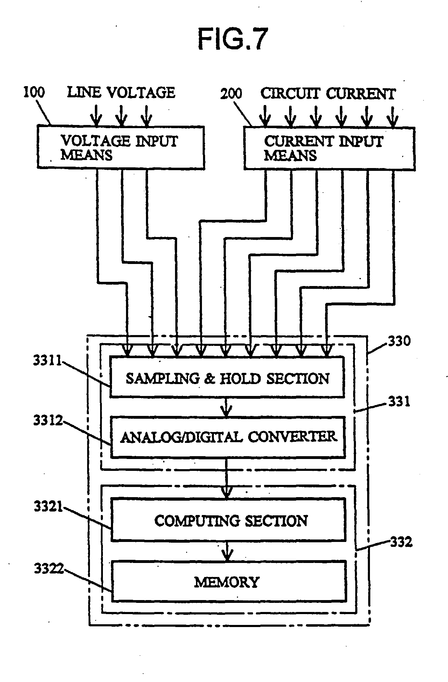

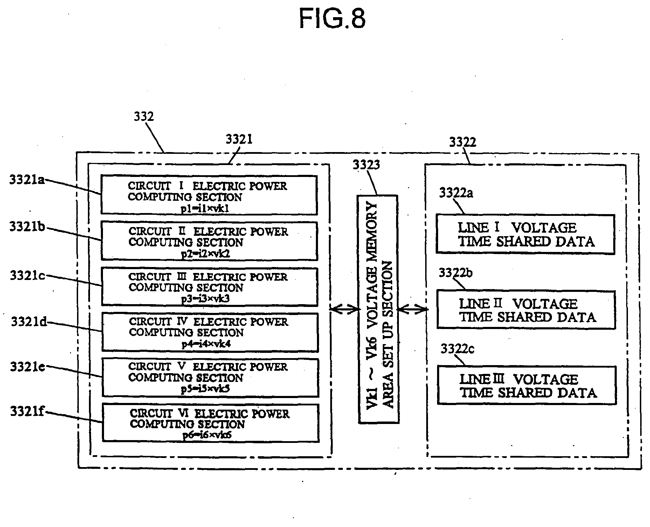

Fig. 7 and Fig. 8 show a different specific structure of a multicircuit type watt meter. In Fig. 7, reference numeral 330 denotes power measuring means, which samples momentary values of voltage and current simultaneously, and it is applied to a method of determining the product of momentary values of voltage and current, the sum of products in one sampling period, and the electric power by the average of the sums in a specific period.

The multicircuit type watt meter shown in Fig. 7 comprises voltage input means 100, current input means 200, and power measuring means 330. The power measuring means 330 comprises time shared measuring means 331 composed of a sampling & hold section 3311 and an A/D converter 3312, and a power computing section 332 composed of a computing section 3321 and a memory 3322.

As shown in Fig. 7, each line voltage passing through the voltage input means 100 is put into the sampling & hold section 3311 of the power measuring means 330 without resort to voltage-current combining means. The current of each circuit passing through the current input means 200 is also put into the sampling & hold circuit 3311 of the power measuring means 330 without resort to current switching means.

In the power measuring means 330 in Fig. 7, the voltage and current are shared in time for a duration of one cycle of alternating current period or integer multiple times of one cycle by the sampling & hold section 3311, and the voltage and current shared in time are sampled and temporarily held, and the temporarily held sampling data is converted into digital data by the A/D converter 3312. In the power computing section 332, the product of time shared measured data of voltage and current is computed, the sum of the products in one sampling period is computed, and further the average of sums of products is determined to compute the electric power. The power computing section 332 is composed of the computing section 3321 and the memory 3322. In the constitution shown in Fig. 7, voltage-current combining means is not present, but in this embodiment, it is provided in the power measuring means 332 as explained below while referring to Fig. 8.

Fig. 8 shows an embodiment in which the voltage-current combining means is provided in the power measuring means 332. In Fig. 8, the power computing section 332 is composed of the computing section 3321, vk1 to vk6 voltage memory area set-up section 3323, and memory 3322, and the computing section 3321 has six power computing sections from circuit I power computing section 3321a to circuit VI power computing section 3321f, and in each power computing section, the time shared momentary power is calculated in the formula

$$pn = in{\times}vkn, \text{ where } n = 1 \text{ to } 6.$$

Herein, i1 to i6 are time shared data of circuit I current to circuit VI current, and vk1 to vk6 are time shared data of line I voltage to line III voltage. However, correspondence of individual vk1 to vk6 to which one of line voltage of line I voltage to line III voltage is determined by specifying the line voltage by setting in the voltage memory area set-up section 3323. The line voltage time shared data of the memory 3322, that is, line I voltage time shared data 3322a to line III voltage time shared data 3322c are, according to the setting in the voltage memory area set-up section 3323, put into six power computing sections of individual circuit I power computing section 3321a to circuit VI power computing section 3321f, and electric power values are computed.

Therefore, the voltage-current combining means is provided in the power computing section 332 by the software. Substantially, however, same as in the embodiment in Fig. 1, the line voltage can be freely combined with any circuit current, and therefore the electric power corresponding to each circuit current can be measured by using any line voltage.

Thus, the embodiment explained in Fig. 7 and Fig. 8 comprises the time shared measuring section 331 for sharing the voltage and current in time by sampling simultaneously in the sampling & hold section 3311 of the power measuring means 330, and converting the time shared sampling data into measured digital data by the A/D converter 3312, and the power computing section 332 for computing the product of time shared data of voltage and current thereof by the computing section 3321 and memory 3322, computing the sum of products in one sampling period from this product, and determining the average of sums of products. Moreover, the voltage-current combining means is provided in the power computing section 332, and memory data of voltage and current are arbitrarily combined, and therefore voltage-current combining means is not required in the hardware, and the electric power can be measured by selecting the voltage input circuit corresponding to the current input circuit by the setting on the software.

Therefore, according to the embodiment, the electric power can be measured by arbitrary combination of circuit currents and line voltages, and hence if the number of feeders differs in each voltage line, the installed circuits for power measurement can be utilized to the full extent. In addition, since the voltage-current combining means is realized by the software, the circuit is simplified and the number of constituent parts can be saved.

(Embodiment 6)

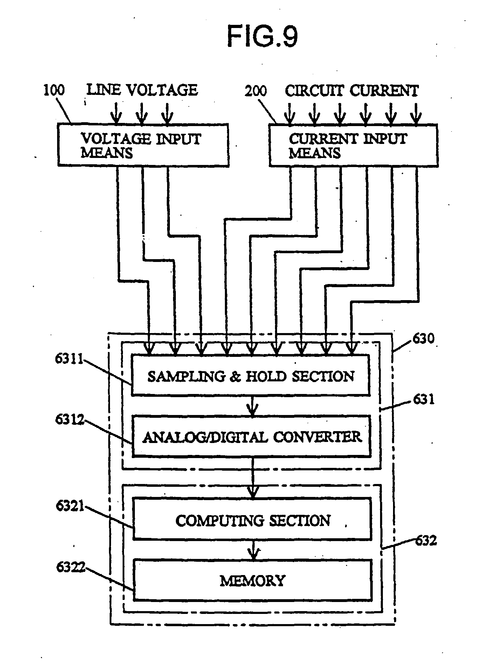

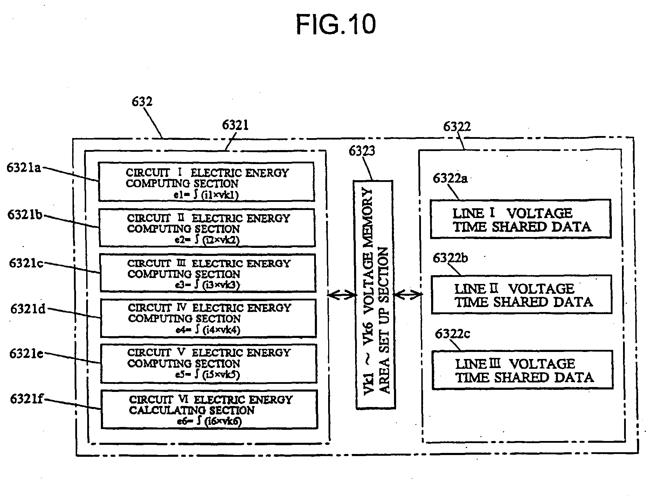

Fig. 9 and Fig. 10 show a different specific structure of a multicircuit type watthour meter. In Fig. 9, reference numeral 630 denotes electric energy measuring means, which samples momentary values of voltage and current simultaneously, and it is applied to a method of determining the product of momentary values of voltage and current, the sum of products in one sampling period, and the electric energy by the integration of its sums.

The multicircuit type watthour meter shown in Fig. 9 comprises voltage input means 100, current input means 200, and electric energy measuring means 630. The electric energy measuring means 630 comprises time shared measuring means 631 composed of a sampling & hold section 6311 and an A/D converter 6312, and an electric energy computing section 632 composed of a computing section 6321 and a memory 6322.

As shown in Fig. 9, each line voltage passing through the voltage input means 100 is put into the sampling & hold section 6311 of the electric energy measuring means 630 without resort to voltage-current combining means. The current of each circuit passing through the current input means 200 is also put into the sampling & hold circuit 6311 of the electric energy measuring means 630 without resort to current combining means.

In the electric energy measuring means 630 in Fig. 9, the voltage and current are shared in time for a duration of one cycle of alternating current period or integer multiple times of one cycle by the sampling & hold section 6311, and the voltage and current shared in time are sampled and temporarily held, and the temporarily held sampling data is converted into digital data by the A/D converter 6312. In the electric energy computing section 632, the product of time shared measured data of voltage and current is computed, the sum of the products in one sampling period is computed, and further the average of sums of products is determined to compute the electric energy. The electric energy computing section 632 is composed of the computing section 6321 and the memory 6322. In the constitution shown in Fig. 9, voltage-current combining means is not present, but in this embodiment, it is provided in the electric energy measuring means 632 as explained below while referring to Fig. 10.

Fig. 10 shows an embodiment in which the voltage-current s combining means is provided in the electric energy measuring means 632. In Fig. 10, the electric energy computing section 632 is composed of the computing section 6321, vk1 to vk6 voltage memory area set-up section 6323, and memory 6322, and the computing section 6321 has six electric energy computing sections from circuit I electric energy computing section 6321a to circuit VI electric energy computing section 6321f, and in each electric energy computing section, the time shared momentary electric energy is calculated in the formula

$$pn = in \times vkn, \text{ where } n = 1 \text{ to } 6.$$

In each electric energy computing section, moreover, the time shared momentary electric energy are integrated to compute the electric energy. That is, the electric energy en is obtained as

$$en = \int pndt = \int (in \times vkn)dt$$

Herein, i1 to i6 are time shared data of circuit I current to circuit VI current, and vk1 to vk6 are time shared data of line I voltage to line III voltage. However, correspondence of individual vk1 to vk6 to which one of line voltage of line I voltage to line III voltage is determined by specifying the line voltage by setting in the voltage memory area set-up section 6323. The line voltage time shared data of the memory 6322, that is, line I voltage time shared data 6322a to line III voltage time shared data 6322c are, according to the setting in the voltage memory area set-up section 6323, put into six electric energy computing sections of individual circuit I electric energy computing section 6321a to circuit VI electric energy computing section 6321f, and electric energy values are computed.

Therefore, the voltage-current combining means is provided in the electric energy computing section 632 by the software. Substantially, however, same as in the embodiment in Fig. 3, the line voltage can be freely combined with any circuit current, and therefore the electric energy corresponding to each circuit current can be measured by using any line voltage.

Thus, the embodiment explained in Fig. 9 and Fig. 10 comprises the time shared measuring section 631 for sharing the voltage and current in time by sampling simultaneously in the sampling & hold section 6311 of the electric energy measuring means 630, and converting the time shared sampling data into measured digital data by the A/D converter 6312, and the electric energy computing section 632 for computing the product of time shared data of voltage and current thereof by the computing section 6321 and memory 6322, computing the sum of products in one sampling period from this product, and determining the integrated value of products. Moreover, the voltage-current combining means is provided in the electric energy computing section 632, and memory data of voltage and current are arbitrarily combined, and therefore voltage-current combining means is not required in the hardware, and the electric energy can be measured by selecting the voltage input circuit corresponding to the current input circuit by the setting on the software.

Therefore, according to the embodiment, the electric energy can be measured by arbitrary combination of circuit currents and line voltages, and hence if the number of feeders differs in each voltage line, the installed circuits for electric energy measurement can be utilized to the full extent. In addition, since the voltage-current combining means is realized by the software, the circuit is simplified and the number of constituent parts can be saved.

(Embodiment 7)

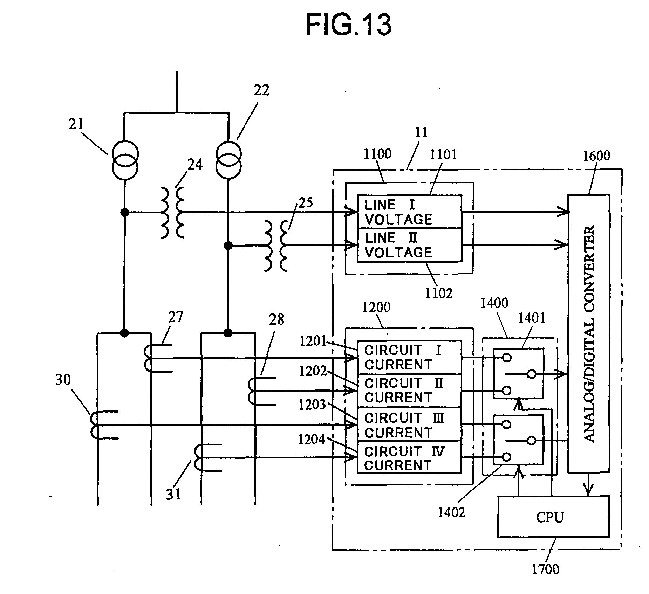

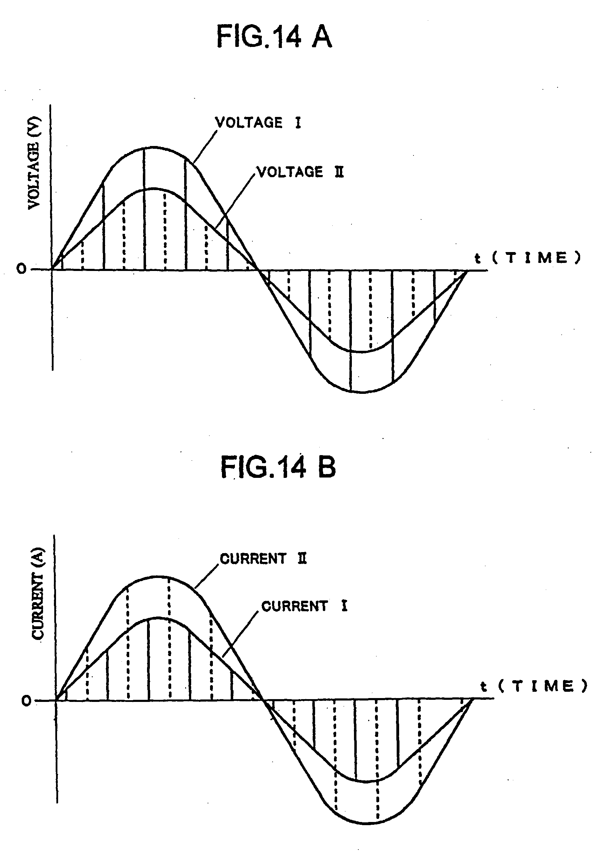

Relating next to a multicircuit type instrument having current input switching means and performing time shared multiplex sampling, an example of multicircuit type watt meter is described below while referring to Fig. 13 and Fig. 14.

In Fig. 13, reference numerals 21 and 22 are step-down transformers of three phases or single phase, and are designed to step down from primary voltage to secondary voltage. Reference numerals 24 and 25 are potential transformers known as PT, 27, 28, 30 and 31 are current transformers for transforming circuit currents into currents for measurement, and 11 is a multicircuit type watt meter. Reference numeral 1100 is voltage input means, which is composed of voltage input means 1101 corresponding to line 1 voltage and voltage input means 1102 corresponding to line 2 voltage. Reference numeral 1200 is current input means, which is composed of current input means 1201 corresponding to circuit 1 current, current input means 1202 corresponding to circuit 2 current, current input means 1203 corresponding to circuit 3 current, and current input means 1204 corresponding to circuit 4 current. Reference numeral 1400 is current input switching means, which is composed of input switching means 1401 for switching between the current input means 1201 and 1202, and input switching means 1402 for switching between the current input means 1203 and 1204. Reference numeral 1600 is an A/D converter for converting an analog signal entered from the voltage input means 1100 and an analog signal entered from the current input means 1200 through the current input switching means into digital signals, and 1700 is a CPU used as a central processing unit.

In thus constituted multicircuit type watt meter, its operation is described below while referring to Fig. 13, Fig. 14A and Fig. 14B.

First, supposing the secondary side of the transformer 21 to be line 1 and the secondary side of the transformer 22 to be line 2, line 1 voltage is supplied from the potential transformer 24 into the voltage input means 1101, and the output of the voltage input means 1101 is put into the A/D converter 1600. Line 2 voltage is supplied from the potential transformer 25 into the voltage input means 1102, and the output of the voltage input means 1102 is put into the A/D converter 1600. Circuit 1 current (line 1 current) is supplied from the transformer 27 into the current input means 1201, circuit 2 (line 2 current) current is supplied from the transformer 28 into the current input means 1202, and the output of the current input means 1201 and output of the current input means 1202 are put into the input switching means 1401. Circuti 3 current (Line 1 current) is supplied from the transformer 30 into the current input means 1203, circuit 4 (line 2 current) is supplied from the transformer 31 into the current input means 1204, and the output of the current input means 1203 and output of the current input means 1204 are put into the input switching means 1402. The current selected in the input switching means 1401 and the current selected in the input switching means 1402 are put into the A/D converter 1600.

The voltage and current fed into the A/D converter 1600 are sinusoidal waves in this example as shown in Fig. 14A and Fig. 14B. Fig. 14A is a voltage waveform, expressing voltage I and voltage II. Fig. 14B is a current waveform, expressing current I and current II. By the command from the CPU 1700, while controlling the switching by the input switching means 1401 and input switching means 1402, time shared multiplex sampling is obtained from the digital output of the A/D converter 1600. For example, a case of sampling sinusoidal waves of voltage and current from two lines by the time sharing number of 8 is explained below.

Suppose to sample line 1 voltage and current (circuit 1 and circuit 3 current) simultaneously, and to sample line 2 voltage and current (circuit 2 and circuit 4 current) simultaneously. A solid-line point in Fig. 14A is supposed to be line 1 voltage, a solid-line point in Fig. 14B to be a sampling point of line 1 current, a broken-line point in Fig. 14A to be line 2 voltage, and a broken-line point in Fig. 14B to be a sampling point of line 2 current. By the control of the CPU 1700, at the solid-line sampling point of line 1, it is switched to the current input means 1201 by the input switching means 1401, and to the current input means 1203 by the input switching means 1402. At the broken-line sampling point of line 2, it is switched to the current input means 1202 by the input switching means 1401, and to the current input means 1204 by the input switching means 1402. Currents of line 1 of solid line and line 2 of broken line are digitally converted in the A/D converter 1600, and digitally converted current data are entered into the CPU 1700 as sampling data at respective points, Voltages of line 1 and line 2 are similarly put into the A/D converter 1600, and after being converted into digital data in the A/D converter 1600 and put into the CPU 1700, they are selectively combined with the current data, and the electric power is computed.

In computing the electric power, on the basis of the voltage and current data thus sampled simultaneously, the momentary power is determined from the product of momentary values of voltage and current, and the momentary value is added for a period of an integer multiple of one alternating-current period, and the average of the period adding the momentary value is determined. The obtained average is the average power of the circuit, that is, the electric power amount.

In the case of time shared multiplex sampling, the sampling indicated by solid line that is the first sampling is called the basic time shared sampling, for example, voltage I in Fig. 14A or current I in Fig. 14B. It is the sampling of the first circuit when switching the circuits and performing time shared sampling of different circuits in multiplex by shifting the time.

The time sharing multiplex number between the sampling point at the basic time shared sampling of time sharing multiplex and a next sampling point, that is, between solid line and solid line in Fig. 14A or Fig. 14B is determined by the number of switching channels of the input switching means 1401 and 1402, that is, the number of current inputs. In the example in Fig. 14A or Fig. 14B, since the number of switching channels is two, the time sharing number in one alternating-current period is 8 times 2, and hence the sampling points are 16. Supposing the number of switching channels to be three, another sampling point is added to the sampling points indicated by broken line between solid line and solid line in Fig. 14A or Fig. 14B, and the time sharing number in one alternating-current period is 24.

Thus, by using the current input switching means, the number of channels of the A/D converter for current is enough by the total number of current inputs to the current input switching means divided by the number of switching channels, so that the multicircuit type watt meter is realized at low cost. Moreover, by time shared multiplex sampling, there is no pause period in data acquisition, and therefore lack of data is avoided, and a circuit with a large load fluctuation may be measured at high precision.

When such multicircuit type watt meter is constituted, the circuit constitution can be simplified by integrating other parts than the CPU with the CPU as ASIC. In Fig. 13, moreover, the potential transformers are provided outside of the multicircuit type watt meter 11, but they may be also incorporated within the multicircuit type watt meter 11.

The number of voltage lines is not limited, and the number of current circuits is not limited either. The time sharing number is not limited as far as the precision of measurements can be maintained. As a matter of course, it is not required that the number of lines be equal to the number of input switching channels. For example, in the case of one voltage line, ten current circuits, and five switching channels of the input switching means, the number of channels of the A/D converter required for current input is 1/5, that is, two channels.

In Fig. 13 showing the multicircuit watt meter using input switching means and performing time shared multiplex sampling, by replacing the multicircuit type watt meter with a multicircuit type watthour meter, it can be used as the watthour meter. Also, by replacing the multicircuit type watt meter with a multicircuit type power factor meter, it can be used as the power factor meter. Further, by replacing the multicircuit type watt meter with a multicircuit type reactive power meter, it can be used as the reactive power meter. Moreover, by replacing the multicircuit type watt meter with a multicircuit type var-hour meter, it can be used as the var-hour meter.

Below are described embodiments of the circuit in Fig. 13 used as multicircuit type watthour meter, multicircuit type power factor meter, multicircuit type reactive power meter, and multicircuit type var-hour meter.

First is explained the case of using as multicircuit type watthour meter. The basic constitution is same as the case of multicircuit type watt meter for time shared multiplex sampling, and description of the constitution of Fig. 13 is omitted.

In this embodiment, the multicircuit type watt meter in Fig. 13 is replaced with a multicircuit type watthour meter, and the CPU 1700 computes the electric energy, instead of the electric power.

In electric energy computation, on the basis of the data of voltage and current sampled simultaneously, the momentary electric power value is determined from the product of momentary values of voltage and current, the momentary electric power values are cumulatively added, and the cumulative sum is the electric energy of the circuit.

In the multicircuit type watthour meter for time shared multiplex sampling, there is no pause period if sampled while switching the circuits, and therefore a circuit having large load fluctuations can be measured at high precision, so that it is more useful than the measurement of momentary values of electric power values. For promotion of energy-saving, it is important to understand the power consumption accurately, and for accurate understanding of power consumption, multiple watthour meters are needed. A large space is required for installing multiple watthour meters, which requires a large cost for installation and material, but in the multicircuit type watthour meter of the invention, since the electric energy of multiple circuits can be measured at high precision, both saving of space and lowering of cost are realized.

Next is explained the case of using the circuit in Fig. 13 as multicircuit type power factor meter. The basic constitution is same as the case of multicircuit type watt meter for time shared multiplex sampling, and description of the constitution of Fig. 13 is omitted.

In this embodiment, the multicircuit type watt meter in Fig. 13 is replaced with a multicircuit type power factor meter, and the CPU 1700 computes the power factor, instead of the electric power.

First, on the basis of the data of voltage and current sampled simultaneously, the momentary electric power is determined from the product of momentary values of voltage and current, the momentary values are added for a period of an integer multiple of one alternating-current period, and the average of the period adding the momentary values is determined. The obtained average is the average power of the circuit, that is, the electric power amount.

On the other hand, from the sampled data of voltage and current, the effective values of voltage and current are calculated, and the apparent power is obtained as the product of the voltage effective value and current effective value, and by dividing the average power by the apparent power, the power factor of the circuit is obtained. That is, supposing the power factor to be $\cos\phi$, it is expressed as

$$\cos\phi = \text{average power/apparent power.}$$

In a low voltage circuit, generally, since there are many branched circuits, when adjusting the power factor in the low voltage circuit, for installation of a power factor adjusting device by power factor computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. Hence by using the multicircuit type power factor meter of the embodiment in the power factor adjusting device for multiple circuits, both saving of space and lowering of cost are realized.

Further is explained the case of using the circuit in Fig. 13 as multicircuit type reactive power meter. The basic constitution is same as the case of multicircuit type watt meter for time shared multiplex sampling, and description of the constitution of Fig. 13 is omitted.

In this embodiment, the multicircuit type watt meter in Fig. 13 is replaced with a multicircuit type reactive power meter, and the CPU 1700 computes the reactive power, instead of the electric power.

As mentioned in the above description of the multicircuit type power factor meter, on the basis of the data of voltage and current sampled simultaneously, the average power and apparent power are determined, and by dividing the average power by the apparent power, the power factor "$\cos\phi$" is obtained. From this power factor $\cos\phi$, the circuit reactance rate "$\sin\phi$" is easily obtained in the following formula.

$$\sin\phi = (1 - \cos^2\phi)^{1/2}$$

From the apparent power and reactance rate, the reactive power is obtained as

reactive power = -$\sin\phi \times$ apparent power.

In a low voltage circuit, generally, since there are many branched circuits, when adjusting the power factor in the low voltage circuit, for installation of a power factor adjusting device by reactive power computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. By using the multicircuit type reactive power meter of the embodiment in such power factor adjusting device for multiple circuits, the effective of saving of space and lowering of cost may be further enhanced.

Also is explained the case of using the circuit in Fig. 13 as multicircuit type var-hour meter. The basic constitution is same as the case of multicircuit type watt meter for time shared multiplex sampling, and description of the constitution of Fig. 13 is omitted.

In this embodiment, the multicircuit type watt meter in Fig. 13 is replaced with a multicircuit type var-hour meter, and the CPU 1700 computes the reactive energy, instead of the electric power.

As mentioned in the above description of the multicircuit type reactive power meter, from the apparent power and reactance rate, the reactive power is obtained as

reactive power = -$\sin\phi \times$ apparent power.

By cumulatively adding the reactive power values, the reactive energy is computed.

In measurement of reactive energy which is an integral value, since time shared multiplex sampling is performed, there is no pause period if sampled while switching the circuits. Therefore, a circuit having large load fluctuations can be measured at high precision, so that it is more useful than the measurement of momentary values such as electric power and reactive power. For effective use of electric power, it is important to understand the reactive energy accurately, and for accurate understanding of reactive energy, multiple var-hour meters are needed. A large space is required for installing multiple var-hour meters, which requires a large cost for installation and material, but in the multicircuit type var-hour meter of the invention, since the reactive energy of multiple circuits can be measured at high precision, both saving of space and lowering of cost are realized.

(Embodiment 8)

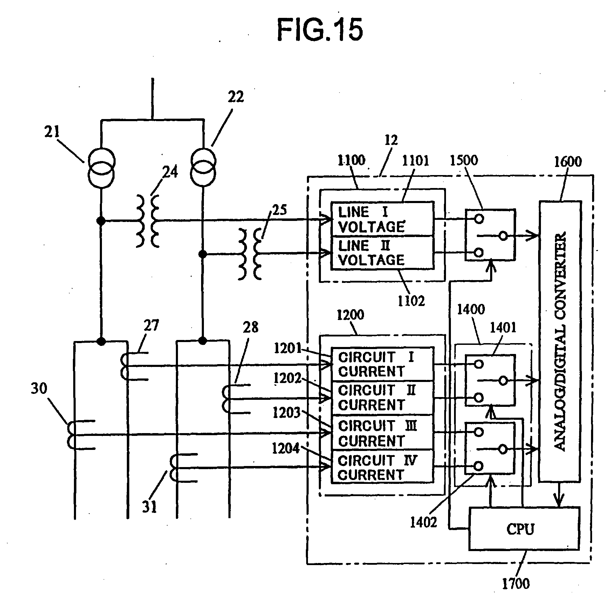

Explained next is other embodiment of a multicircuit type instrument having input switching means and performing time shared multiplex sampling. This embodiment comprises voltage input switching means, and is designed to switch voltage inputs by the voltage input switching means. Relating to this multicircuit type instrument having voltage input switching means, an example of multicircuit type watt meter is described below while referring to Fig. 14A, Fig. 14B and Fig. 15.

First, supposing the secondary side of the transformer 21 to be line 1 and the secondary side of the transformer 22 to be line 2, line 1 voltage is supplied from the potential transformer 24 into the voltage input means 1101, line 2 voltage is supplied from the potential transformer 25 into the voltage input means 1102, and the output of the voltage input means 1101 and output of the voltage input means 1102 are put into voltage input switching means 1500. The output of the voltage input means 1101 and output of the voltage input means 1102 are selected by the voltage input switching means 1500, and the selected output is fed into the A/D converter 1600.

On the other hand, circuit 1 current is supplied from the transformer 27 into the current input means 1201, circuit 2 current is supplied from the transformer 28 into the current input means 1202, and the output of the current input means 1201 and output of the current input means 1202 are put into the current input switching means 1401. The output of the current input means 1201 and output of the current input means 1202 are selected by the current input switching means 1401, and the selected output is fed into the A/D converter 1600. Circuit 3 current is supplied from the transformer 30 into the current input means 1203, circuit 4 current is supplied from the transformer 31 into the current input means 1204, and the output of the current input means 1203 and output of the current input means 1204 are put into the current input switching means 1402. The output of the current input means 1203 and output of the current input means 1204 are selected in the current input switching means 1402, and the selected output is fed into the A/D converter 1600.

The voltage and current fed into the A/D converter 1600 are sinusoidal waves in this example as shown in Fig. 14A and Fig. 14B. By the command from the CPU 1700, while controlling the switching by the current input switching means 1401, current input switching means 1402 and voltage input switching means 1500, time shared multiplex sampling is obtained from the digital output of the A/D converter 1600. For example, a case of sampling sinusoidal waves of voltage and current from two lines by the time sharing number of 8 is explained below.

Suppose to sample line 1 voltage and current (circuit 1 and circuit 3 current) simultaneously, and to sample line 2 voltage and current (circuit 2 and circuit 4 current) simultaneously. A solid-line point in Fig. 14A is supposed to be line 1 voltage, a solid-line point in Fig. 14B to be a sampling point of line 1 current, a broken-line point in Fig. 14A to be line 2 voltage, and a broken-line point in Fig. 14B to be a sampling point of line 2 current. By the control of the CPU 1700, at the solid-line sampling point of line 1, it is switched to the voltage input means 1101 by the voltage input switching means 1500, to the current input means 1201 by the current input switching means 1401, and to the current input means 1203 by the current input switching means 1402. At the broken-line sampling point of line 2, it is switched to the voltage input means 1102 by the voltage input switching means 1500, to the current input means 1202 by the current input switching means 1401, and to the current input means 1204 by the input switching means 1402. Voltages and currents of line 1 of solid line and line 2 of broken line are digitally converted in the A/D converter 1600, and digitally converted voltage and current data are entered into the CPU 1700 as sampling data at respective points, and the electric power is computed.

In computing the electric power, on the basis of the voltage and current data thus sampled simultaneously, the momentary power is determined from the product of momentary values of voltage and current, and the momentary value is added for a period of an integer multiple of one alternating-current period, and the average of the period adding the momentary value is determined. The obtained average is the average power of the circuit, that is, the electric power amount.

The time sharing multiplex number between the sampling point at the basic time shared sampling of time sharing multiplex and a next sampling point, that is, between solid line and solid line in Fig. 14A and Fig. 14B is determined by the number of switching channels of the current input switching means 1401 and 1402, that is, the number of current inputs. In the example in Fig. 14A and Fig. 14B, since the number of switching channels is two, the time sharing number in one alternating-current period is 8 times 2, and hence the sampling points are 16. Supposing the number of switching channels to be three, another sampling point is added to the sampling points indicated by broken line between solid line and solid line in Fig. 14, and the time sharing number in one alternating-current period is 24.

Thus, by using the voltage input switching means and current input switching means, for voltage input and current input, the A/D converter is required to have the number of channels only in the sum of the total number of inputs to the voltage input switching means divided by the number of switching channels of the voltage input switching means, and the total number of inputs to the current input switching means divided by the number of switching channels of the current input switching means. By using the voltage input switching means and current input switching means, the multicircuit type watt meter is realized at low cost. As in this embodiment, by using the voltage input switching means in addition to the current input switching means, its effect is further enhanced. Moreover, by time shared multiplex sampling, there is no pause period in data acquisition, and therefore lack of data is avoided, and a circuit with a large load fluctuation may be measured at high precision.

When such multicircuit type watt meter is constituted, the circuit constitution can be simplified by integrating other parts than the CPU with the CPU as ASIC. In Fig. 15, moreover, the potential transformers are provided outside of the multicircuit type watt meter 11, but they may be also incorporated within the multicircuit type watt meter 11.

The number of voltage lines is not limited, and the number of current circuits is not limited either. The time sharing number is not limited as far as the precision of measurements can be maintained. As a matter of course, it is not required that the number of lines be equal to the number of input switching channels. For example, in the case of one voltage line, ten current circuits, and five switching channels of the input switching means, the number of channels of the A/D converter required for current input is 1/5, that is, two channels.

In Fig. 15 showing the multicircuit watt meter using input switching means and performing time shared multiplex sampling, by replacing the multicircuit type watt meter with a multicircuit type watthour meter, it can be used as the watthour meter. Also, by replacing the multicircuit type watt meter with a multicircuit type power factor meter, it can be used as the power factor meter. Further, by replacing the multicircuit type watt meter with a multicircuit type reactive power meter, it can be used as the reactive power meter. Moreover, by replacing the multicircuit type watt meter with a multicircuit type var-hour meter, it can be used as the var-hour meter.

Below are described embodiments of the circuit in Fig. 15 used as multicircuit type watthour meter, multicircuit type power factor meter, multicircuit type reactive power meter, and multicircuit type var-hour

meter. First is explained the case of using as multicircuit type watthour meter. The basic constitution is same as the case of multicircuit type watt meter for time shared multiplex sampling, and description of the constitution of Fig. 15 is omitted.

In this embodiment, the multicircuit type watt meter in Fig. 15 is replaced with a multicircuit type watthour meter, and the CPU 1700 computes the electric energy, instead of the electric power.

In electric energy computation, on the basis of the data of voltage and current sampled simultaneously, the momentary electric power value is determined from the product of momentary values of voltage and current, the momentary electric power values are cumulatively added, and the cumulative sum is the electric energy of the circuit.

In the multicircuit type watthour meter for time shared multiplex sampling, there is no pause period if sampled while switching the circuits, and therefore a circuit having large load fluctuations can be measured at high precision, so that it is more useful than the measurement of momentary values such as electric power values. For promotion of energy-saving, it is important to understand the power consumption accurately, and for accurate understanding of power consumption, multiple watthour meters are needed. A large space is required for installing multiple watthour meters, which requires a large cost for installation and material, but in the multicircuit type watthour meter of the invention, since the electric energy of multiple circuits can be measured at high precision, both saving of space and lowering of cost are realized.

Next is explained the case of using the circuit in Fig. 15 as multicircuit type power factor meter. The basic constitution is same as the case of multicircuit type watt meter for time shared multiplex sampling, and description of the constitution of Fig. 15 is omitted.

In this embodiment, the multicircuit type watt meter in Fig. 15 is replaced with a multicircuit type power factor meter, and the CPU 1700 computes the power factor, instead of the electric power.

First, on the basis of the data of voltage and current measured simultaneously, the momentary electric power is determined from the product of momentary values of voltage and current, the momentary values are added for a period of an integer multiple of one alternating-current period, and the average of the period adding the momentary values is determined. The obtained average is the average power of the circuit, that is, the electric power amount.

On the other hand, from the sampled data of voltage and current, the effective values of voltage and current are calculated, and the apparent power is obtained as the product of the voltage effective value and current effective value, and by dividing the average power by the apparent power, the power factor of the circuit is obtained. That is, supposing the power factor to be $\cos\phi$, it is expressed as

$$\cos\phi = \text{average power/apparent power.}$$

In a low voltage circuit, generally, since there are many branched circuits, when adjusting the power factor in the low voltage circuit, for installation of a power factor adjusting device by power factor computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. Hence by using the multicircuit type power factor meter of the embodiment in such power factor adjusting device for multiple circuits, both saving of space and lowering of cost are realized.

Further is explained the case of using the circuit in Fig. 15 as multicircuit type reactive power meter. The basic constitution is same as the case of multicircuit type watt meter for time shared multiplex sampling, and description of the constitution of Fig. 15 is omitted.

In this embodiment, the multicircuit type watt meter in Fig. 15 is replaced with a multicircuit type reactive power meter, and the CPU 1700 computes the reactive power, instead of the electric power.

As mentioned in the above description of the multicircuit type power factor meter, on the basis of the data of voltage and current sampled simultaneously, the average power and apparent power are determined, and by dividing the average power by the apparent power, the power factor "$\cos\phi$" is obtained, From this power factor $\cos\phi$, the circuit reactance rate "$\sin\phi$" is easily obtained in the following formula.

$$\sin\phi = (1 - \cos^2\phi)^{1/2}$$

From the apparent power and reactance rate, the reactive power is obtained as

$$\text{reactive power} = -\sin\phi \cdot \text{apparent power.}$$

In a low voltage circuit, generally, since there are many branched circuits, when adjusting the power factor in the low voltage circuit, for installation of a power factor adjusting device by reactive power computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. By using the multicircuit type reactive power meter of the embodiment in such power factor adjusting device for multiple circuits, the effective of saving of space and lowering of cost may be further enhanced.

Also is explained the case of using the circuit in Fig. 15 as multicircuit type var-hour meter. The basic constitution is same as the case of multicircuit type watt meter for time shared multiplex sampling, and description of the constitution of Fig. 15 is omitted.

In this embodiment, the multicircuit type watt meter in Fig. 15 is replaced with a multicircuit type var-hour meter, and the CPU 1700 computes the reactive energy, instead of the electric power.

As mentioned in the above description of the multicircuit type reactive power meter, from the apparent power and reactance rate, the reactive power is obtained as

$$\text{reactive power} = -\sin\phi \times \text{apparent power}.$$

By cumulatively adding the reactive power values, the reactive energy is computed.

In measurement of reactive energy which is an integral value, since time shared multiplex sampling is performed, there is no pause period if sampled while switching the circuits. Therefore, a circuit having large load fluctuations can be measured at high precision, so that it is more useful than the measurement of momentary values such as electric Power and reactive power. For effective use of electric power, it is important to understand the reactive energy accurately, and for accurate understanding of reactive energy, multiple var-hour meters are needed. A large space is required for installing multiple var-hour meters, which requires a large cost for installation and material, but in the multicircuit type var-hour meter of the invention, since the reactive energy of multiple circuits can be measured at high precision, both saving of space and lowering of cost are realized.

(Embodiment 9)

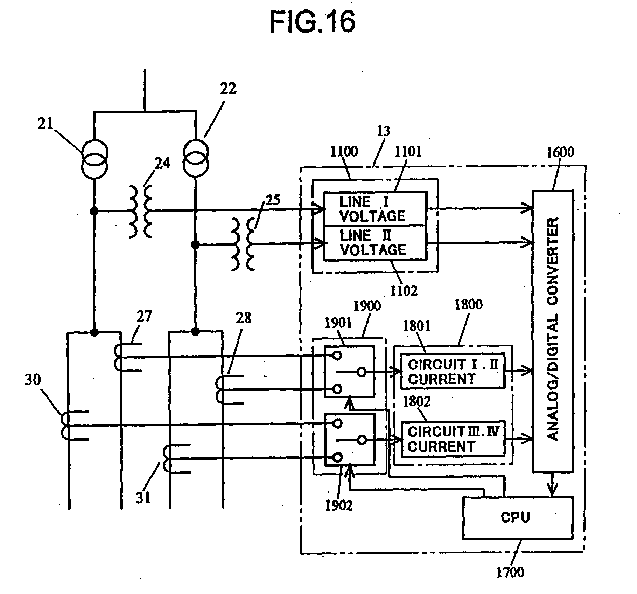

Explained below is another embodiment of a multicircuit type instrument having input switching means and performing time shared multiplex sampling. This embodiment comprises current input switching means, and this current input switching means is disposed in the front stage of the current input means, that is, between the current transformer and the current input means. Relating to this multicircuit type instrument having current input switching means disposed between the current transformer and the current input means, an example of multicircuit type watt meter is described below while referring to Fig. 14A, Fig. 14B and Fig. 16.

In Fig. 16, the secondary side of the transformer 21 is supposed to be line 1 and the secondary side of the transformer 22 to be line 2. Line 1 voltage is supplied from the potential transformer 24 into the voltage input means 1101, the output of the voltage input means 1101 is put into the A/D converter 1600, line 2 voltage is supplied from the potential transformer 25 into the voltage input means 1102, and the output of the voltage input means 1102 is put into the A/V converter 1600. Line 1 (circuit 1) current from the current transformer 27 and line 2 (circuit 2) current from the current transformer 28 are fed into current input switching means 1901, and line 1 (circuit 3) current from the current transformer 30 and line 2 (circuit 4) current from the current transformer 31 are fed into current input switching means 1902. The line 1 current from the current transformer 27 and line 2 current from the current transformer 28 fed into the current input switching means 1901 are selected by the current input switching means 1901, and fed into the current input means 1801 , and the line 1 current from the current transformer 30 and line 2 current from the current transformer 31 fed into the current input switching means 1902 are selected by the current input switching means 1902, and fed into the current input means 1802. The output of the current input means 1801 and output of the current input means 1802 are fed into the A/D converter 1600.

The voltage and current fed into the A/D converter 1600 are sinusoidal waves in this example as shown in Fig. 14A and Fig. 14B. By the CPU 1700, while controlling the switching by the current input switching means 1901 and current input switching means 1902, time shared multiplex sampling is obtained from the digital output of the A/D converter 1600. For example, a case of sampling sinusoidal waves of voltage and current from two lines by the time sharing number of 8 is explained below.

Suppose to sample line 1 voltage and current simultaneously, and to sample line 2 voltage and current simultaneously. A solid-line point in Fig. 14A is supposed to be line 1 voltage, a solid-line point in Fig. 14B to be a sampling point of line 1 current, a broken-line point in Fig. 14A to be line 2 voltage, and a broken-line point in Fig. 14B to be a sampling point of line 2 current. By the control of the CPU 1700, at the solid-line sampling point of line 1, the current input switching means 1901 switches the current inputs from the current transformer 27 and current transformer 28 to the current input of line 1, that is, the current input from the current transformer 27, and the current input switching means 1902 switches the current inputs from the current transformer 30 and current transformer 31 to the current input of line 1, that is, the current input from the current transformer 30. At the solid-line sampling point of line 2, the current input switching means 1901 switches the current inputs from the current transformer 27 and current transformer 28 to the current input of line 2, that is, the current input from the current transformer 28, and the current input switching means 1902 switches the current inputs from the current transformer 30 and current transformer 31 to the current input of line 2, that is, the current input from the current transformer 31. The voltage input means 1101 and 1102 are connected directly to the A/D converter 1600.

Voltages and currents of line 1 of solid line and line 2 of broken line are digitally converted in the A/D converter 1600, and digitally converted voltage and current data are entered into the CPU 1700 as sampling data at respective points, and the electric power is computed.

The time sharing multiplex number between the sampling point at the basic time shared sampling of time sharing multiplex and a next sampling point, that is, between solid line and solid line in Fig. 14A and Fig. 14B is determined by the number of switching channels of the current input switching means 1801 and 1802, that is, the number of current inputs. In the example in Fig. 14A and Fig. 14B, since the number of switching channels is two, the time sharing number in one alternating-current period is 8 times 2, and hence the sampling points are 16. Supposing the number of switching channels to be three, another sampling point is added to the sampling points indicated by broken line between solid line and solid line in Fig. 14, and the time sharing number in one alternating-current period is 24.

Thus, by using the current input switching means, for current input, the A/D converter is required to have the number of channels only in the number dividing the total number of current inputs by the number of switching channels, and the multicircuit type watt meter is realized at low cost. Moreover, by time shared multiplex sampling, there is no pause period in data acquisition, and therefore lack of data is avoided, and a circuit with a large load fluctuation may be measured at high precision.

When such multicircuit type watt meter is constituted, the circuit constitution can be simplified by integrating other parts than the CPU with the CPU as ASIC. In Fig. 16, moreover, the potential transformers are provided outside of the multicircuit type watt meter 11, but they may be also incorporated within the multicircuit type watt meter 11.

The number of voltage lines is not limited, and the number of current circuits is not limited either. The time sharing number is not limited as far as the precision of measurements can be maintained. As a matter of course, it is not required that the number of lines be equal to the number of input switching channels. For example, in the case of one voltage line, ten current circuits, and five switching channels of the current input switching means, the number of channels of the A/D converter required for current input is 1/5, that is, two channels.

In Fig. 16 showing the multicircuit watt meter using input switching means and performing time shared multiplex sampling, by replacing the multicircuit type watt meter with a multicircuit type watthour meter, it can be used as the watthour meter. Also, by replacing the multicircuit type watt meter with a multicircuit type power factor meter, it can be used as the power factor meter. Further, by replacing the multicircuit type watt meter with a multicircuit type reactive power meter, it can be used as the reactive power meter. Moreover, by replacing the multicircuit type watt meter with a multicircuit type var-hour meter, it can be used as the var-hour meter.

Below are described embodiments of the circuit in Fig. 16 used as multicircuit type watthour meter, multicircuit type power factor meter, multicircuit type reactive power meter, and multicircuit type var-hour meter.

First is explained the case of using as multicircuit type watthour meter. The basic constitution is same as the case of multicircuit type watt meter for time shared multiplex sampling, and description of the constitution of Fig. 16 is omitted.

In this embodiment, the multicircuit type watt meter in Fig. 16 is replaced with a multicircuit type watthour meter, and the CPU 1700 computes the electric energy, instead of the electric power.

In electric energy computation, on the basis of the data of voltage and current sampled simultaneously, the momentary electric power value is determined from the product of momentary values of voltage and current, the momentary electric power values are cumulatively added, and the cumulative sum is the electric energy of the circuit.

In the multicircuit type watthour meter for time shared multiplex sampling, there is no pause period if sampled while switching the circuits, and therefore a circuit having large load fluctuations can be measured at high precision, so that it is more useful than the measurement of momentary values such as electric power values. For promotion of energy-saving, it is important to understand the power consumption accurately, and for accurate understanding of power consumption, multiple watthour meters are needed. A large space is required for installing multiple watthour meters, which requires a large cost for installation and material, but in the multicircuit type watthour meter of the invention, since the electric energy of multiple circuits can be measured at high precision, both saving of space and lowering of cost are realized.

Next is explained the case of using the circuit in Fig. 16 as multicircuit type power factor meter. The basic constitution is same as the case of multicircuit type watt meter for time shared multiplex sampling, and description of the constitution of Fig. 16 is omitted.

In this embodiment, the multicircuit type watt meter in Fig. 16 is replaced with a multicircuit type power factor meter, and the CPU 1700 computes the power factor, instead of the electric power.

First, on the basis of the data of voltage and current sampled simultaneously, the momentary electric power is determined from the product of momentary values of voltage and current, the momentary values are added for a period of an integer multiple of one alternating-current period, and the average of the period adding the momentary values is determined. The obtained average is the average power of the circuit, that is, the electric power amount.

On the other hand, from the sampled data of voltage and current, the effective values of voltage and current are calculated, and the apparent power is obtained as the product of the voltage effective value and current effective value, and by dividing the average power by the apparent power, the power factor of the circuit is obtained. That is, supposing the power factor to be $\cos\phi$, it is expressed as

$$\cos\phi = \text{average power/apparent power.}$$

In a low voltage circuit, generally, since there are many branched circuits, when adjusting the power factor in the low voltage circuit, for installation of a power factor adjusting device by power factor computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. Hence by using the multicircuit type power factor meter of the embodiment in this power factor adjusting device for multiple circuits, both saving of space and lowering of cost are realized.

Further is explained the case of using the circuit in Fig. 16 as multicircuit type reactive power meter. The basic constitution is same as the case of multicircuit type watt meter for time shared multiplex sampling, and description of the constitution of Fig. 16 is omitted.

In this embodiment, the multicircuit type watt meter in Fig. 16 is replaced with a multicircuit type reactive power meter, and the CPU 1700 computes the reactive power, instead of the electric power.

As mentioned in the above description of the multicircuit type power factor meter, on the basis of the data of voltage and current sampled simultaneously, the average power and apparent power are determined, and by dividing the average power by the apparent power, the power factor "$\cos\phi$" is obtained, From this power factor $\cos\phi$, the circuit reactance rate "$\sin\phi$" is easily obtained in the following formula.

$$\sin\phi = (1 - \cos^2\phi)^{1/2}$$

From the apparent power and reactance rate, the reactive power is obtained as

$$\text{reactive power} = -\sin\phi \times \text{apparent power.}$$

In a low voltage circuit, generally, since there are many branched circuits, when adjusting the power factor in the low voltage circuit, for installation of a power factor adjusting device by reactive power computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. By using the multicircuit type reactive power meter of the embodiment in such power factor adjusting device for multiple circuits, the effective of saving of space and lowering of cost may be further enhanced.

Also is explained the case of using the circuit in Fig. 16 as multicircuit type var-hour meter. The basic constitution is same as the case of multicircuit type watt meter for time shared multiplex sampling, and description of the constitution of Fig. 16 is omitted.

In this embodiment, the multicircuit type watt meter in Fig. 16 is replaced with a multicircuit type var-hour meter, and the CPU 1700 computes the reactive energy, instead of the electric power.

As mentioned in the above description of the multicircuit type reactive power meter, from the apparent power and reactance rate, the reactive power is obtained as

$$\text{reactive power} = -\sin\phi \times \text{apparent power.}$$

By cumulatively adding the reactive power values, the reactive energy is computed.

In measurement of reactive energy which is an integral value, since time shared multiplex sampling is performed, there is no pause period if sampled while switching the circuits. Therefore, a circuit having large load fluctuations can be measured at high precision, so that it is more useful than the measurement of momentary values such as electric power and reactive power. For effective use of electric power, it is important to understand the reactive energy accurately, and for accurate understanding of reactive energy, multiple var-hour meters are needed. A large space is required for installing multiple var-hour meters, which requires a large cost for installation and material, but in the multicircuit type var-hour meter of the invention, since the reactive energy of multiple circuits can be measured at high precision, both saving of space and lowering of cost are realized.

(Embodiment 10)

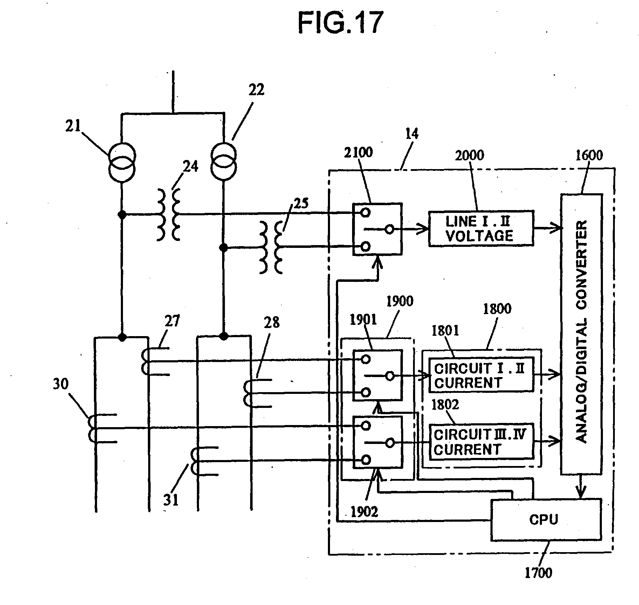

Explained below is a different embodiment of a multicircuit type instrument having input switching means and performing time shared multiplex sampling. This embodiment comprises voltage input switching means in addition to current input switching means, and is designed to switch voltage inputs by the voltage input switching means. In the embodiment, this voltage input switching means is disposed in the front stage of the voltage input means, that is, between the potential transformer and the voltage input means, and the current input switching means is disposed in the front stage of the current input means, that is, between the current transformer and the current input means. Relating to this multicircuit type instrument having voltage input switching means and current input switching means, an example of multicircuit type watt meter is described below while referring to Fig. 14A, Fig. 14B and Fig. 17.

First, the secondary side of the transformer 21 is supposed to be line 1 and the secondary side of the transformer 22 to be line 2. Line 1 voltage from the potential transformer 24 and line 2 voltage from the potential transformer 25 are fed into the voltage input switching means 2100. The output of the voltage input switching means 2100 selected by the voltage input switching means 2100 is put into the A/D converter 1600 through voltage input means 2000. On the other hand, line 1 (circuit 1) current from the current transformer 27 and line 2 (circuit 2) current from the current transformer 28 are fed into current input switching means 1901, and line 1 (circuit 3) current from the current transformer 30 and line 2 (circuit 4) current from the current transformer 31 are fed into current input switching means 1902. The line 1 current from the current transformer 27 and line 2 current from the current transformer 28 fed into the current input switching means 1901 are selected by the current input switching means 1901, and fed into the current input means 1801, and the line 1 current from the current transformer 30 and line 2 current from the current transformer 31 fed into the current input switching means 1902 are selected by the current input switching means 1902, and fed into the current input means 1802. The output of the current input means 1801 and output of the current input means 1802 are fed into the A/D converter 1600.

The voltage and current fed into the A/D converter 1600 are sinusoidal waves in this example as shown in Fig. 14A and Fig. 14B. By the CPU 1700, while controlling the switching by the voltage input means 2000, current input means 1801 and current input means 1802, time shared multiplex sampling is obtained from the digital output of the A/D converter 1600. For example, a case of sampling sinusoidal waves of voltage and current from two lines by the time sharing number of 8 is explained below.

Suppose to sample line 1 voltage and current simultaneously, and to sample line 2 voltage and current simultaneously. A solid-line point in Fig. 14A is supposed to be line 1 voltage, a solid-line point in Fig. 14B to be a sampling point of line 1 current, a broken-line point in Fig. 14A to be line 2 voltage, and a broken-line point in Fig. 14B to be a sampling point of line 2 current. By the control of the CPU 1700, at the solid-line sampling point of line 1, the voltage input switching means 2100 selects the line 1 voltage from the potential transformer 24. The current input switching means 1901 switches the current inputs from the current transformer 27 and current transformer 28 to the current input of line 1, that is, the current input from the current transformer 27, and the current input switching means 1902 switches the current inputs from the current transformer 30 and current transformer 31 to the current input of line 1, that is, the current input from the current transformer 30.

At the broken-line sampling point of line 2, the voltage input switching means 2100 selects the line 2 voltage from the potential transformer 25. The current input switching means 1901 switches the current inputs from the current transformer 27 and current transformer 28 to the current input of line 2, that is, the current input from the current transformer 28, and the current input switching means 1902 switches the current inputs from the current transformer 30 and current transformer 31 to the current input of line 2, that is, the current input from the current transformer 31.

Voltages and currents of line 1 of solid line and line 2 of broken line are digitally converted in the A/D converter 1600, and digitally converted voltage and current data are entered into the CPU 1700 as sampling data at respective points, and the electric power is computed.

The time sharing multiplex number between the sampling point at the basic time shared sampling of time sharing multiplex and a next sampling point, that is, between solid line and solid line in Fig. 14A and Fig. 14B is determined by the number of switching channels of the current input switching means 1901 and 1902, that is, the number of current inputs. In the example in Fig. 14A and Fig. 14B, since the number of switching channels is two, the time sharing number in one alternating-current period is 8 times 2, and hence the sampling points are 16. Supposing the number of switching channels to be three, another sampling point is added to the sampling points indicated by broken line between solid line and solid line in Fig. 14A and Fig. 14B, and the time sharing number in one alternating-current period is 24.

Thus, by using the voltage input switching means and current input switching means, for the total number of inputs to the voltage input means and current input means, the A/D converter is required to have the number of channels only by the sum of the total number of inputs to the voltage input switching means divided by the number of switching channels of the voltage input switching means, and the total number of inputs to the current input switching means divided by the number of switching channels of the current input switching means. Therefore, by using the voltage input switching means and current input switching means, the multicircuit type watt meter is realized at low cost. Still more, as in the embodiment, the effects may be further enhanced by installing the voltage input switching means in addition to the current input switching means. Moreover, by time shared multiplex sampling, there is no pause period in data acquisition, and therefore lack of data is avoided, and a circuit with a large load fluctuation may be measured at high precision.

When such multicircuit type watt meter is constituted, the circuit constitution can be simplified by integrating other parts than the CPU with the CPU as ASIC. In Fig. 17, moreover, the potential transformers are provided outside of the multicircuit type watt meter 11, but they may be also incorporated within the multicircuit type watt meter 11.

The number of voltage lines is not limited, and the number of current circuits is not limited either. The time sharing number is not limited as far as the precision of measurements can be maintained. As a matter of course, it is not required that the number of lines be equal to the number of input switching channels. For example, in the case of one voltage line, ten current circuits, and five switching channels of the input switching means, the number of channels of the A/D converter required for current input is 1/5, that is, two channels.

Without changing the current input section composed of current input switching means 1901, current input switching means 1902, current input means 1801 and current input means 1802 as shown in Fig.17, the voltage input section composed of input switching means 2100 and voltage input means 2000 in Fig. 17 may be composed of voltage input means 1101, voltage input means 1102 and voltage input switching means 1500 as shown in Fig. 15.

Or, without changing the voltage input section composed of voltage input switching means 2100 and voltage input means 2000 as shown in Fig.17, the current input section composed of current input switching means 1901, current input switching means 1902, current input means 1801 and current input means 1802 in Fig. 17 may be composed of current input means 1201, current input means 1202, current input means 1203, current input means 1204, current input switching means 1401 and current input switching means 1402 as shown in Fig. 15.

In Fig. 17 showing the multicircuit watt meter using the voltage input switching means and the current input switching means, and performing time shared multiplex sampling, by replacing the multicircuit type watt meter with a multicircuit type watthour meter, it can be used as the watthour meter. Also, by replacing the multicircuit type watt meter with a multicircuit type power factor meter, it can be used as the power factor meter. Further, by replacing the multicircuit type watt meter with a multicircuit type reactive power meter, it can be used as the reactive power meter. Moreover, by replacing the multicircuit type watt meter with a multicircuit type var-hour meter, it can be used as the var-hour meter.

Below are described embodiments of the circuit in Fig. 17 used as multicircuit type watthour meter, multicircuit type power factor meter, multicircuit type reactive power meter, and multicircuit type var-hour meter.

First is explained the case of using as multicircuit type watthour meter. The basic constitution is same as the case of multicircuit type watt meter for time shared multiplex sampling, and description of the constitution of Fig. 17 is omitted.

In this embodiment, the multicircuit type watt meter in Fig. 17 is replaced with a multicircuit type watthour meter, and the CPU 1700 computes the electric energy, instead of the electric power.

In electric energy computation, on the basis of the data of voltage and current sampled simultaneously, the momentary electric power value is determined from the product of momentary values of voltage and current, the momentary electric power values are cumulatively added, and the cumulative sum is the electric energy of the circuit.

In the multicircuit type watthour meter for time shared multiplex sampling, there is no pause period if sampled while switching the circuits, and therefore a circuit having large load fluctuations can be measured at high precision, so that it is more useful than the measurement of momentary values such as electric power values. For promotion of energy-saving, it is important to understand the power consumption accurately, and for accurate understanding of power consumption, multiple watthour meters are needed. A large space is required for installing multiple watthour meters, which requires a large cost for installation and material, but in the multicircuit type watthour meter of the invention, since the electric energy of multiple circuits can be measured at high precision, both saving of space and lowering of cost are realized.

Next is explained the case of using the circuit in Fig. 17 as multicircuit type power factor meter. The basic constitution is same as the case of multicircuit type watt meter for time shared multiplex sampling, and description of the constitution of Fig. 17 is omitted.

In this embodiment, the multicircuit type watt meter in Fig. 17 is replaced with a multicircuit type power factor meter, and the CPU 1700 computes the power factor, instead of the electric power.

First, on the basis of the data of voltage and current sampled simultaneously, the momentary electric power is determined from the product of momentary values of voltage and current, the momentary values are added for a period of an integer multiple of one alternating-current period, and the average of the period adding the momentary values is determined. The obtained average is the average power of the circuit, that is, the electric power amount.

On the other hand, from the sampled data of voltage and current, the effective values of voltage and current are calculated, and the apparent power is obtained as the product of the voltage effective value and current effective value, and by dividing the average power by the apparent power, the power factor of the circuit is obtained. That is, supposing the power factor to be $\cos\phi$, it is expressed as

$$\cos\phi = \text{average power/apparent power.}$$

In a low voltage circuit, generally, since there are many branched circuits, when adjusting the power factor in the low voltage circuit, for installation of a power factor adjusting device by power factor computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. Hence by using the multicircuit type power factor meter of the embodiment in this power factor adjusting device for multiple circuits, both saving of space and lowering of cost are realized.

Further is explained the case of using the circuit in Fig. 17 as multicircuit type reactive power meter. The basic constitution is same as the case of multicircuit type watt meter for time shared multiplex sampling, and description of the constitution of Fig. 17 is omitted.

In this embodiment, the multicircuit type watt meter in Fig. 17 is replaced with a multicircuit type reactive power meter, and the CPU 1700 computes the reactive power, instead of the electric power.

As mentioned in the above description of the multicircuit type power factor meter, on the basis of the data of voltage and current sampled simultaneously, the average power and apparent power are determined, and by dividing the average power by the apparent power, the power factor "cos$\phi$" is obtained. From this power factor cos$\phi$, the circuit reactance rate "sin$\phi$" is easily obtained in the following formula.

$$\sin\phi = (1 - \cos^2\phi)^{1/2}$$

From the apparent power and reactance rate, the reactive power is obtained as

reactive power = -sin$\phi$ × apparent power.

In a low voltage circuit, generally, since there are many branched circuits, when adjusting the power factor in the low voltage circuit, for installation of a power factor adjusting device by reactive power computation and control, a large space is needed for installing multiple power factor adjusting devices for single circuits, and it requires a large cost for installation and material. It is therefore preferred to adjust the power factor of multiple circuits by one power factor adjusting device from the viewpoint of saving space and lowering the cost. By using the multicircuit type reactive power meter of the embodiment in such power factor adjusting device for multiple circuits, the effective of saving of space and lowering of cost may be further enhanced.

Also is explained the case of using the circuit in Fig. 17 as multicircuit type var-hour meter. The basic constitution is same as the case of multicircuit type watt meter for time shared multiplex sampling, and description of the constitution of Fig. 17 is omitted.

In this embodiment, the multicircuit type watt meter in Fig. 17 is replaced with a multicircuit type var-hour meter, and the CPU 1700 computes the reactive energy, instead of the electric power.

As mentioned in the above description of the multicircuit type reactive power meter, from the apparent power and reactance rate, the reactive power is obtained as

reactive power = -sin$\phi$ × apparent power.

By cumulatively adding the reactive power values, the reactive energy is computed.

In measurement of reactive energy which is an integral value, since time shared multiplex sampling is performed, there is no pause period if sampled while switching the circuits. Therefore, a circuit having large load fluctuations can be measured at high precision, so that it is more useful than the measurement of momentary values such as electric energy and reactive power. For effective use of electric power, it is important to understand the reactive energy accurately, and for accurate understanding of reactive energy, multiple var-hour meters are needed. A large space is required for installing multiple var-hour meters, which requires a large cost for installation and material, but in the multicircuit type var-hour meter of the invention, since the reactive energy of multiple circuits can be measured at high precision, both saving of space and lowering of cost are realized.

(Embodiment 11)

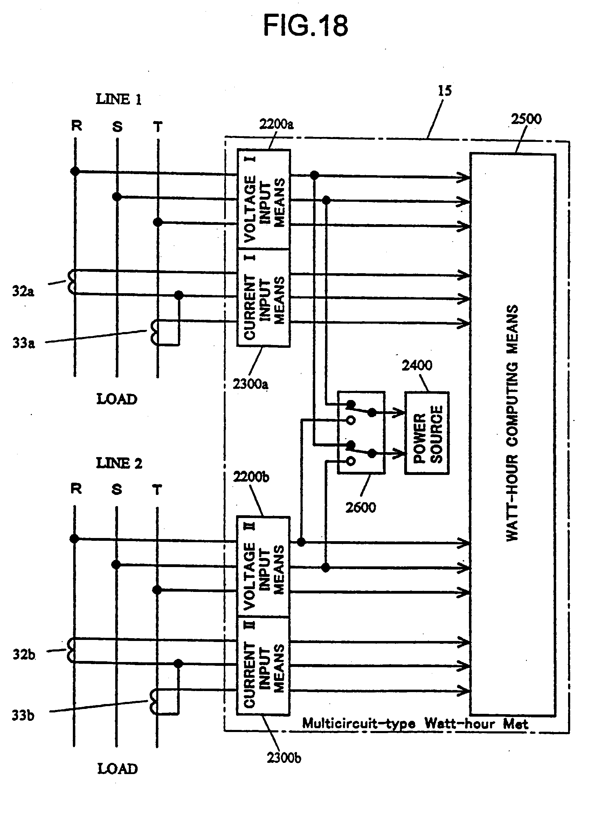

Referring now to Fig. 18, the invention relates to a multicircuit type instrument constituted to supply source power for the multicircuit type instrument itself stably regardless of power failure if power failure should occur in any line of the voltage of multiple lines.

In Fig. 18, line 1 (LINE 1) and line 2 (LINE 2) are individually independent alternating-current electric power circuits. Reference numeral 15 denotes a multicircuit type watthour meter of the embodiment. From the alternating-current electric power circuit line 1, line voltage of line 1 is supplied into electric watthour computing means 2500 through voltage I input means 2200a. Reference numerals 32a and 33a are current transformers for measuring the circuit currents of line 1, and outputs of the current transformers 32a and 33a are fed into the watthour computing means 2500 through current I input means 2300a as a two-phase current. On the other hand, from the alternating-current electric power circuit line 2, line voltage of line 2 is supplied into the watthour computing means 2500 through voltage II input means 2200b. Reference numerals 32b and 33b are current transformers for measuring the circuit currents of line 2, and outputs of the current transformers 32b and 33b are fed into the watthour computing means 2500 through current II input means 2300b as a two-phase current.

Reference numeral 2600 is power source switching means for switching the supply of source power of the multicircuit type watthour meter 15 from either line 1 or line 2. The voltage input of either line 1 or line 2 selected by this power source switching means 2600 is connected to a power source section 2400 of the multicircuit type watthour meter 15, and an electric power for operating the multicircuit type watthour meter 15 is supplied to the multicircuit type watthour meter 15.

By thus constituted multicircuit type watthour meter 15, the electric energy of line 1 and line 2 is measured. Either voltage input of line 1 or line 2 selected by the power source switching means 2600 is connected to the power source section 2400 of the multicircuit type watthour meter 15, and the multicircuit type watthour meter 15 is put into operation.

First, suppose the line voltage of line 1 fed through the voltage I input means 2200a is fed into the power source section 2400 through the power source switching means 2600 to operate the multicircuit type watthour meter 15. In the multicircuit type watthour meter 15, the electric energy of line 1 is computed and measured by the watthour computing means 2500 by the line voltage of line 1 supplied through the voltage I input means 2200a and the circuit current of line 1 supplied through the current I input means 2300a. Similarly, the electric energy of line 2 is computed and measured by the watthour computing means 2500 by the line voltage of line 2 supplied through the voltage II input means 2200b and the circuit current of line 2 supplied through the current II input means 2300b.

Supposing power failure occurs at line 1 side, the line voltage of line 1 is lost. At this time, the power source switching means 2600 switches over from the line voltage of line 1 supplied through the voltage I input means 2200a to the line voltage of line 2 supplied through the voltage II input means 2200b, and the electric power is continuously supplied into the power source section 2400, so that the multicircuit type watthour meter 15 can measure the electric energy of line 2 continuously by the line voltage of line 2 supplied through the voltage II input means 2200b at the line 2 side not having power failure and the circuit current of line 2 supplied through the current II input means 2300b.

Thus, if power failure should occur in one line while measuring the electric energy of two independent voltage lines, the electric power is supplied to the multicircuit type watthour meter from the remaining line having the voltage, so that the electric energy of the remaining line having the voltage can be measured continuously. In this embodiment, the multicircuit type instrument is the watthour meter, but the same effects are obtained if the multicircuit type instrument is watt meter, power factor meter, reactive power meter, or varhour meter.

(Embodiment 12)

This embodiment comprises priority order selecting means for switching the power sources in a multicircuit type instrument constituted so as to supply source power for the multicircuit type instrument itsef stably regardless of power failure.

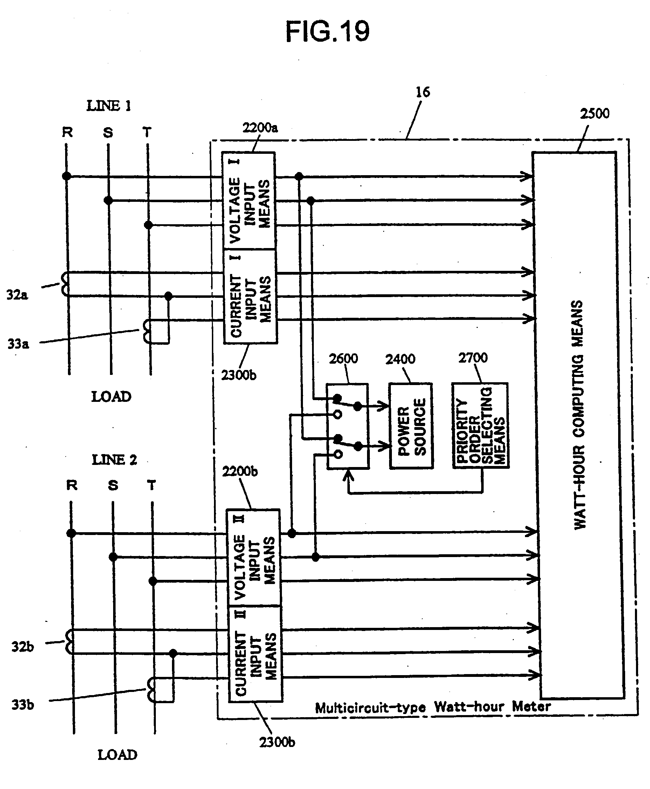

A constitution of this embodiment is shown in Fig. 19. In Fig. 19, reference numeral 2700 is priority order selecting means, and 16 is a multicircuit type watthour meter. The other constitution is same as in Fig. 18 explained above. In thus constituted multicircuit type watthour meter, by the command of the priority order selecting means 2700, power source switching means 2600 usually selects the line voltage of line 1 supplied through voltage I input means 2200a. Therefore, in the power source section 2400, the line voltage of line 1 supplied through the voltage I input means 2200a is supplied by priority, and the multicircuit type watthour meter 16 is operated by the line 1 side voltage. In the multicircuit type watthour meter 16, the electric energy of line 1 is computed and measured by the watthour computing means 2500 by the line voltage of line 1 supplied through the voltage I input means 2200a and the circuit current of line 1 supplied through the current I input means 2300a. Similarly, the electric energy of line 2 is computed and measured by the watthour computing means 2500 by the line voltage of line 2 supplied through the voltage II input means 2200b and the circuit current of line 2 supplied through the current II input means 2300b.

Supposing power failure occurs at line 1 side, the line voltage of line 1 is lost. At this time, the power source switching means 2600 switches over from the line voltage of line 1 supplied through the voltage I input means 2200a to the line voltage of line 2 supplied through the voltage II input means 2200b, and the electric power is continuously supplied into the power source section 2400, so that the multicircuit type watthour meter 16 can measure the electric energy of line 2 continuously by the line voltage of line 2 supplied through the voltage II input means 2200b at the line 2 side not having power failure and the circuit current of line 2 supplied through the current II input means 2300b.

Consequently, when the power is recovered at the line 1 side, after the line 1 side voltage is stabilized, by the command of the priority order selecting means 2700, the power source switching means 2600 switches the voltage to be supplied to the power source section 2400 to the line 1 side voltage. If power failure occurs at the line 2 side, the power source switching means 2600 selects the line 1 side voltage, and the voltage is supplied to the power source section 2400 from the line 1 side, so that the multicircuit type watthour meter 16 can operate continuously without trouble, so that the electric energy of the line 1 side can be measured.

Thus, by preliminarily selecting the priority order of the line, which has less power failures and less voltage changes, to be connected to the power source section 2400, if power failure and recovery are repeated, the electric power can be stably supplied into the multicircuit type watthour meter 16, and the electric energy of the line having the voltage can be measured stably and reliably by reducing the transient phenomena due to repeated power failures. In this embodiment, the multicircuit type instrument is the watthour meter, but the same effects are obtained if the multicircuit type instrument is watt meter, power factor meter, reactive power meter, or var-hour meter.

(Embodiment 13)

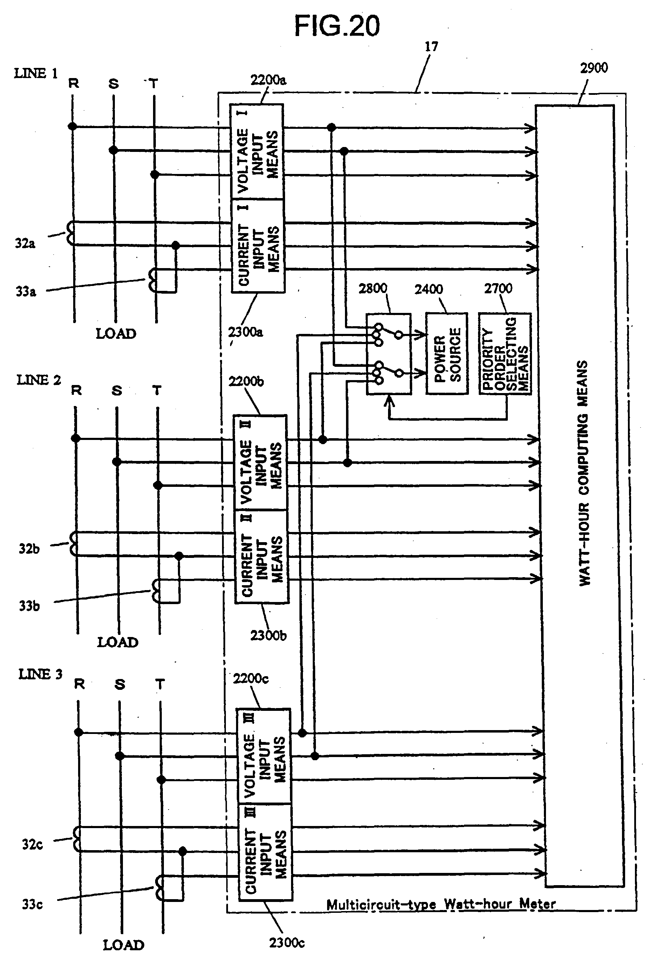

Fig. 20 shows an example of an alternating-current electric power circuit consisting of three independent lines. Line 1 and line 2 are same as in the embodiments in Fig. 18 and Fig. 19.

From alternating-current electric power circuit line 3, line voltage of line 3 is supplied into watthour computing means 2500 through voltage III input means 2200c. Reference numerals 32c and 33c are current transformers for measuring the circuit currents of line 3, and outputs of the current transformers 32c and 33c are fed into the watthour computing means 2900 through current III input means 2300c as a two-phase current. Reference numeral 17 is a multicircuit type watthour meter for measuring the electric energy of the alternating-current electric power circuit having mutually independent three lines, and reference numeral 2800 is power source switching means for selecting the line to be connected to the power source section 2400 from three lines of the alternating-current electric power circuit and switching whether power source electric power is supplied or not. The other constitution is same as in the embodiment shown in Fig. 19, and duplicate explanation is omitted.

In thus constituted multicircuit type watthour meter, by the command of the priority order selecting means 2700, power source switching means 2800 usually selects the line voltage of line 1 supplied through voltage I input means 2200a. Therefore, in the power source section 2400, the line voltage of line 1 supplied through the voltage I input means 2200a is supplied by priority, and the multicircuit type watthour meter 17 is operated by the line 1 side voltage. The multicircuit type watthour meter 17 computes and measures the electric energy of line 1 by the line voltage of line 1 supplied through the voltage I input means 2200a and the circuit current of line 1 supplied through the current I input means 2300a. Similarly, the multicircuit type watthour meter 17 computes and measures the electric energy of line 2 by the line voltage of line 2 supplied through the voltage II input means 2200b and the circuit current of line 2 supplied through the current II input means 2300b. Likewise, the multicircuit type watthour meter 17 computes and measures the electric energy of line 3 by the line voltage of line 3 supplied through the voltage III input means 2200c and the circuit current of line 3 supplied through the current III input means 2300c.

In the power source switching section 2800, one line voltage is supplied each from the voltage I input means 2200a, voltage II input means 2200b, and voltage III input means 2200c. In the power source switching section 2800, the voltage to the power source section 2400 is switched over according to the command from the priority order selecting means 2700 so that the three lines may be sequentially selected and switched in the priority order of , for example, line I voltage, line II voltage and line III voltage. By feeding the output voltage from the power source switching section 2800 into the power source section 2400, the multicircuit type watthour meter 17 is put in operation. Therefore, usually, the line voltage of line 1 supplied through the voltage I input means 2200a is fed by priority into the power source section 2400, and the multicircuit type watthour meter 17 is operated by the line 1 side voltage.

If voltage is lost in the line I alternating-current electric power circuit due to power failure or the like, according to the command of the priority order selecting means 2700, the power source switching means 2800 switches over from the voltage of the voltage I input means 2200a to the voltage of the voltage II input means 2200b, and the voltage is continuously supplied into the power source section 2400, and the watthour computing means 2900 computes and measures the electric energy of the line 2 alternating-current electric power circuit and line 3 alternating-current electric power circuit. Consequently, when the power is recovered in the line 1 alternating-current electric power circuit, after the voltage is stabilized, by the priority order selecting means 2700, the power source switching means 2800 switches the voltage to be supplied to the power source section 2400 from the line 1 alternating-current electric power circuit. If power failure occurs in the line 2 alternating-current electric power circuit, since the line 1 alternating-current electric power circuit is selected by the priority order selecting means 2700, the power is continuously supplied to the power source section 2400, so that the multicircuit type watthour meter 17 can operate continuously, so that the electric energy of the line 1 alternating-current electric power circuit and line 3 alternating-current electric power circuit can be measured.

If the line 1 alternating-current electric power circuit and line 2 alternating-current electric power circuit both fall in power failure state, by the priority order selecting means 2700, since it is switched by the power source switching means 2800 to supply the voltage to the power source section 2400 from the line 3 alternating-current electric power circuit, the electric energy of the line 3 alternating-current electric power circuit can be measured. When the power is recovered in the line 1 alternating-current electric power circuit, if the power failure state of the line 2 alternating-current electric power circuit continues, after the voltage is stabilized in the line 1 alternating-current electric power circuit, by the priority order selecting means 2700, it is switched by the power source switching means 2800 to supply the voltage to the power source section 2400 from the line 1 alternating-current electric power circuit.

Thus, in order that the power source switching section 2800 may always switch to the voltage of the line higher in the priority order, the priority order selecting means 2700 determines the connection destination, and supplies electric power to the power source section 2400. Instead of selecting the circuit having the voltage to be connected to the power source circuit 2400 and changing the connection on every occasion of occurrence of power failure in the alternating-current electric power circuit of the line for feeding electric power to the power source section 2400, when the power is recovered in the alternating-current electric power circuit of higher priority order, immediately after the voltage is stabilized, the electric power is supplied to the power source section 2400 from the alternating-current electric power circuit of higher priority order. Therefore, if power failure and recover occur frequently in the alternating-current electric power circuit of each line, power supply may be done stably and securely by reducing the power source switching, and the electric energy in the alternating-current electric power circuit of the remaining line having the voltage can be securely measured.

Fig. 20 shows three lines of alternating-current electric power circuit, but it is similarly applied to three or more lines for using by specifying the priority order in the alternating-current electric power circuit of all lines. The greater the number of lines, the more stable is the operation of the lines by supplying electric power to the multicircuit type instrument by specifying the lines with the priority order. In this embodiment, the multicircuit type instrument is the watthour meter, but the same effects are obtained if the multicircuit type instrument is watt meter, power factor meter, reactive power meter, or var-hour meter.

(Embodiment 14)

A current transformer of the invention suited to be used in the multicircuit type instrument is described below while referring to the drawings.

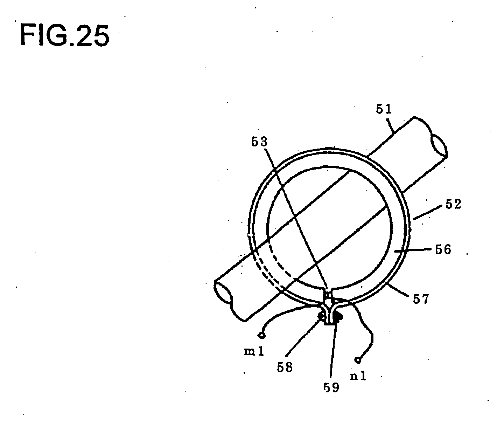

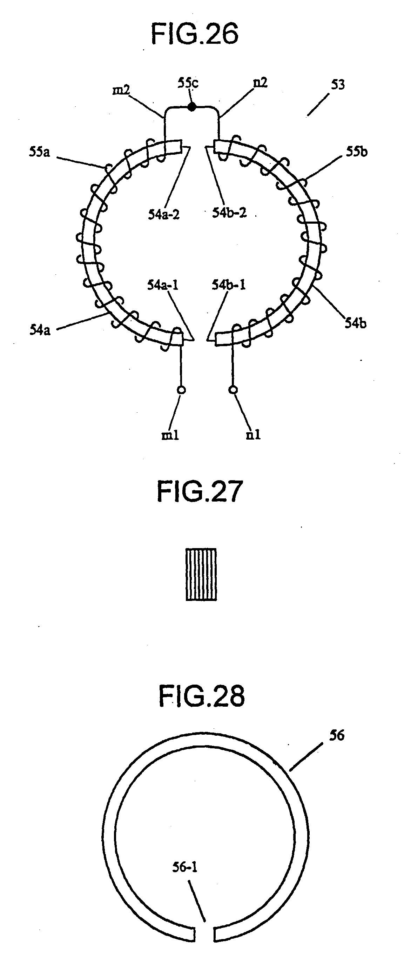

In Fig. 25, reference numeral 51 is a wire to be measured, and 52 is a split type current transformer. Reference numeral 53 is a magnetic circuit assembly, 56 is a nonmagnetic container, 57 is a band fixing element, 58 is a screw, and 59 is a nut. Fig. 26 shows a constitution of the magnetic circuit assembly. As shown in Fig. 26, the magnetic circuit assembly 53 is composed of two divided magnetic elements 54a and 54b, and two windings 55a and 55b wound on the two divided magnetic elements 54a and 54b according to the current transformer rating. The two divided magnetic elements 54a and 54b form a complete closed magnetic circuit by adhering butt to butt their cut sections 54a-1 and 54b-1, and 54a-2 and 54b-2, respectively. One end m2 of the winding 55a and one end n2 of the winding 55b are connected so as to be of additional polarity, and other end m1 of the winding 55a and other end n1 of the winding 55b are output terminals of this split type current transformer. Fig. 27 is a sectional view of the magnetic elements 54a and 54b.

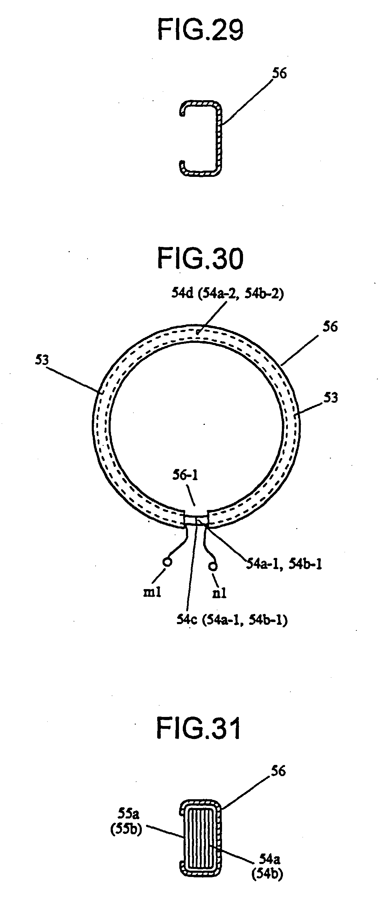

Fig. 28 shows the nonmagnetic container 56. The nonmagnetic container 56 is made of an elastic material, and it is a ring in appearance, being separated by the portion indicated by 56-1 (this separated portion is hereinafter called the opening). Fig. 29 shows a sectional shape of the nonmagnetic container 56. Fig. 30 shows an enclosed state of the magnetic circuit assembly 53 by the nonmagnetic container 56, and Fig. 31 shows a sectional view in an enclosed state of the magnetic circuit assembly 53 by the nonmagnetic container 56. In Fig. 31, inside of the nonmagnetic container 56 are accommodated the magnetic element 54a wound with the winding 55a, and the magnetic element 54b wound with the winding 55b. The butt junction 54c of the cut section 54a-1 of the magnetic element 54a and the cut section 54b-1 of the magnetic element 54b is positioned nearly in the center of the opening 56-1 of the nonmagnetic container 56, and the butt junction 54d of the cut section 54a-2 of the magnetic element 54a and the cut section 54b-2 of the magnetic element 54b is positioned nearly in the center of the main body of the nonmagnetic container 56 (the position remotest from the opening, in the center of the arc formed by the nonmagnetic container 56 main body). The connection ends of one end m2 of the winding 55a and one end n2 of the winding 55b wound around the magnetic elements 54a and 54b are accommodated in the nonmagnetic container 56. Moreover, as shown in Fig. 25, the outer circumference of the nonmagnetic container 56 is tightened by the band fixing element 57, thereby fortifying the magnetic coupling of the butt junction of the magnetic element 54a and magnetic element 54b (the junction 54c of the surface 54a-1 and surface 54b-1, and junction 54d of the surface 54a-2 and surface 54b-2). The band fixing element 57 is tightened by the screw 58 and nut 59 at its opening.

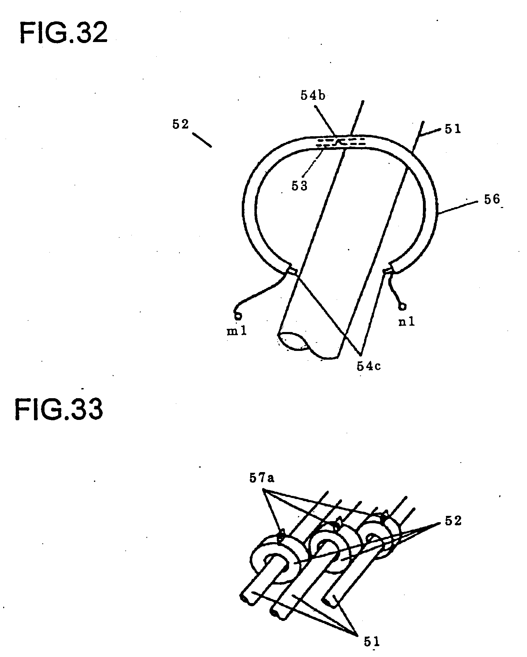

Relating to the split type current transformer thus assembled as shown in Fig. 30, a method of placing so as to surround the wire 51 to be measured as shown in Fig. 25 is explained below. Since the nonmagnetic container 56 is made of an elastic material, the butt junction 54c can be opened by using the butt junction 54d of the two divided magnetic element 54a and magnetic element 54b as the fulcrum as shown in Fig. 32. Therefore, after opening the butt junction 54c and passing in the wire to be measured 51, the butt junction 54c is closed again, and therefore it can be placed easily by tightening the outer circumference of the nonmagnetic container 56 by the band fixing element 57.

Fig. 33 shows a state of installing plural split type current transformers in plural wires to be measured disposed at narrow intervals. According to the split type current transformer of the embodiment, two divided magnetic elements are contained in the elastic nonmagnetic container which can be opened, and the nonmagnetic container is tightened by one band fixing element, and therefore if plural wires to be measured are disposed at narrow intervals, it is possible to install easily in a narrow space. Moreover, since the tightening portion 57a is disposed at one position only, the tightening portion 57a may be easily positioned always at the upper side of the plural disposed wire groups, so that working efficiency may be enhanced. It, however, does not mean that the tightening portion 57a must be always positioned at the upper side of the plural disposed wire groups. The tightening portion 57a may be selected in its position depending on the condition of installation.

Further according to the split type current transformer of the embodiment, since the two divided magnetic elements are contained in a nonmagnetic container of one-body structure, it can be installed so that the same surfaces may always contact with each other. It is particularly effective when it is required to join the cut sections butt to butt with each other, such as the case in which the magnetic element is cut off from a ring core. Moreover, since it is designed to tighten by the band fixing element, a high contact is obtained at the abutting surfaces, and the abutting surfaces are not deviated. Therefore, a high magnetic coupling may be always maintained. Actually, the gap in the magnetic circuit is closely related to the excitation current and has effects on the output characteristics, and hence it is an important matter how to heighten the tightness of the abutting surfaces of the magnetic element. Still more, since one end of two windings wound around the magnetic element is connected to the additional polarity inside the nonmagnetic container, and it is not necessary to connect when installing the split type current transformer, and there is no possibility of wrong connection when installing, It is further possible to lower the risk of wire breakage.

In this embodiment, the sectional shape of the nonmagnetic container is shown in Fig. 29, but the section of the nonmagnetic container is not limited to this shape alone, and the shape is not particularly limited as far as it is designed to envelope the magnetic circuit assembly wound with windings.

(Embodiment 15)

Other embodiment of the current transformer of the invention suited to be used in the multicircuit type instrument is described below while referring to the accompanying drawings.

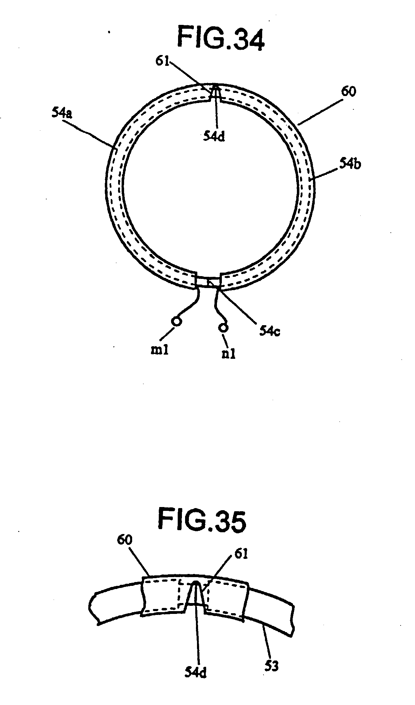

In Fig. 34, reference numeral 60 is an elastic nonmagnetic container, and a notch 61 is provided near the butt junction 54d of the magnetic element 54a and magnetic element 54b. Fig. 35 is its magnified view. In Fig. 35, an inverted-V notch 61 is provided inside of the fulcrum having the elastic nonmagnetic container 60. By forming this notch 61, the inside of the nonmagnetic container 60 is more easily expanded, and when opening the opening side of the nonmagnetic container 60, a wider opening angle is obtained, which is a great benefit.

(Embodiment 16)

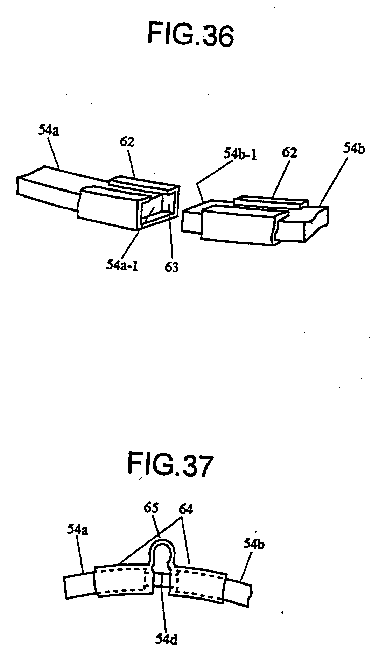

Fig. 36 shows a different embodiment of the current transformer of the invention. In Fig. 36, reference numeral 62 is an elastic nonmagnetic container, 54a is one of the divided magnetic elements, and 54b is other divided magnetic element. This embodiment relates to the relation of the nonmagnetic container 62 and the magnetic elements 54a and 54b near the opening.

Fig. 36 shows an opened state of the opening. At the magnetic element 54a side, the end 54a-1 of the magnetic element 54a is retracted inside of the nonmagnetic container 62. On the other hand, at the magnetic element 54b side, the end 54b-1 of the magnetic element 54b is projected from the end of the nonmagnetic container 62. The inside 63 of the nonmagnetic container 62 at the magnetic element 54a side serves as the guide of the end of the magnetic element 54b. That is, when the end 54a-1 of the magnetic element 54a and the end 54b-1 of the magnetic element 54b are joined butt to butt, by inserting the end of the magnetic element 54b along the inside 63 of the nonmagnetic container 62, the end 54a-1 and end 54b-1 can be easily joined without deviation, not requiring any particular positioning.

Therefore, the joining precision is high at the butt junction 54c of the magnetic element 54a and magnetic element 54b, and a secure magnetic coupling is obtained, and therefore the split type current transformer high in reliability in installation and high in working efficiency is obtained.

(Embodiment 17)

Fig. 37 shows other different embodiment of the current transformer of the invention. In Fig. 37, reference numeral 64 is a nonmagnetic container, 54a is one of the divided magnetic elements, and 54b is other divided magnetic element. This embodiment relates to the structure of the nonmagnetic container 64 at the fulcrum near the butt junction 54d of the magnetic element 54a and magnetic element 54b. In this embodiment, an Ω-shaped loop 65 is provided at the fulcrum of the nonmagnetic container 64, and by the elasticity of this loop 65, the opening angle of the opening of the nonmagnetic container 64 is widened. In this embodiment, the same effect is obtained if the portion of the Ω-shape is formed in an inverted-U shape.

Such shape may be easily realized by molding a resin. By forming the fulcrum in a loop shape, the elasticity is more easily obtained, and it is advantageously possible to form an integral structure by using a resin of relatively low elasticity.

(Embodiment 18)

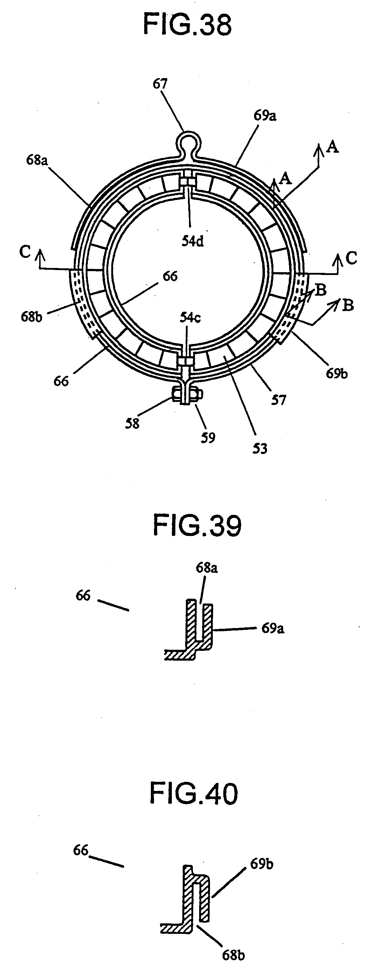

Fig. 38 shows a further different embodiment of the current transformer of the invention. In Fig. 38, the same parts as in Fig. 25 to Fig. 37 are identified with same reference numerals.

Fig. 38 shows a tightened state of a magnetic circuit assembly 53 accommodated in a nonmagnetic container 66 by a band fixing element 57. Reference numeral 67 is a fulcrum provided in the nonmagnetic container 66, 68a and 68b are band fixing element accommodating parts provided in the nonmagnetic container 66, and the band fixing element accommodating parts 68a and 68b are provided on the outer circumference of the nonmagnetic container 66. Fig. 39 is a sectional view of part A-A of the band fixing element accommodating part 68a shown in Fig. 38. In Fig. 39, reference numeral 68a is a guide groove opened upward, and the band fixing element accommodating part 68a is formed of the main body of the nonmagnetic container 66 and an outer wall 69a. Fig. 40 is a sectional view of part B-B of the band fixing element accommodating parts 68b shown in Fig. 38. In Fig. 40, reference numeral 68b is a guide groove opened downward, and the band fixing element accommodating part 68b is formed of the main body of the nonmagnetic container 66 and an outer wall 69b. By thus constituting the band fixing element accommodating parts 68a and 68b, the outer walls 69a and 69b serve as guide for mounting the band fixing element 57, and the band fixing element 57 can be hardly detached by the upward groove 68a and downward groove 68b.

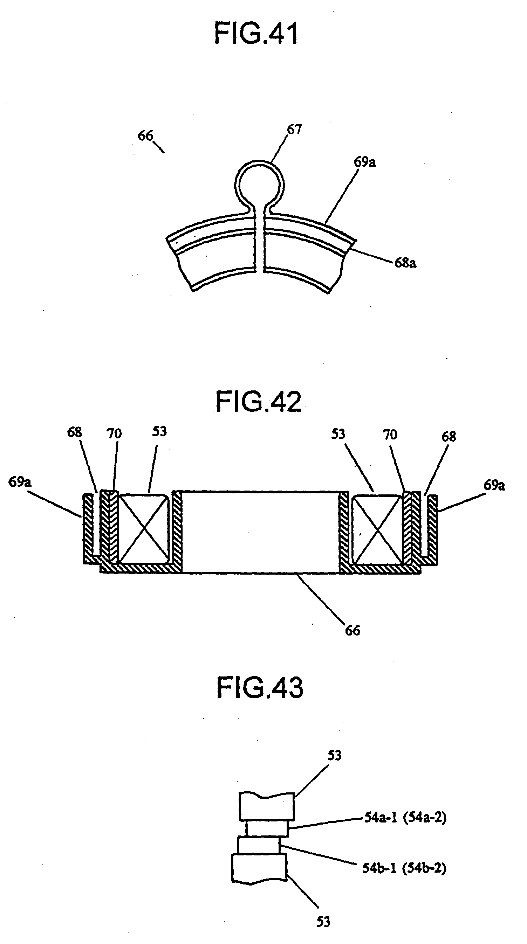

Fig. 41 is a detailed drawing of the fulcrum 67 provided in part of the outer circumference formed of the outer wall 69a of the band fixing element accommodating part 68a. Part of the outer wall 69a is formed in an Ω-shape as the fulcrum 67, and the right and left sides of the nonmagnetic container 66 are connected only by the fulcrum 67 formed in the Ω-shape to be in one body. When the fulcrum 67 is constituted as shown in Fig. 41, the band fixing element 57 is contained in the guide groove 68a and 68b formed of the main body of the nonmagnetic container 66 and the outer wall 69a, and therefore the band fixing element 57 does not interfere with the fulcrum 67, and tightening by the band fixing element 57 may be uniform over the entire circumference of the nonmagnetic container 66. Besides, by forming the fulcrum in the Ω-shape, the elasticity is obtained more easily, and hence the opening 54c can be opened more easily and widely, so that the working efficiency in installation may be substantially enhanced.

Fig. 42 shows a section of part C-C of the current transformer in embodiment 18 shown in Fig. 38. When accommodating the magnetic circuit assembly 53 into the nonmagnetic container 66, a band elastic element 70 is inserted in the gap between the nonmagnetic container 66 and magnetic circuit assembly 53 along the magnetic circuit assembly 53. The band elastic element 70 serves as a cushion to the magnetic circuit assembly 53, and when the nonmagnetic container 66 is tightened by the band fixing element 57, the magnetic circuit assembly 53 receives a pressure in the contracting direction by the elastic force of the magnetic element 70. Therefore, at the butt junctions 54c and 54d of the magnetic elements 54a and 54b, the pressure is mutually received between the magnetic element ends 54a-1 and 54b-1, and between the magnetic element ends 54a-2 and 54b-2, so that it is effective to tighten firmly without causing gap due to inclination of surfaces.

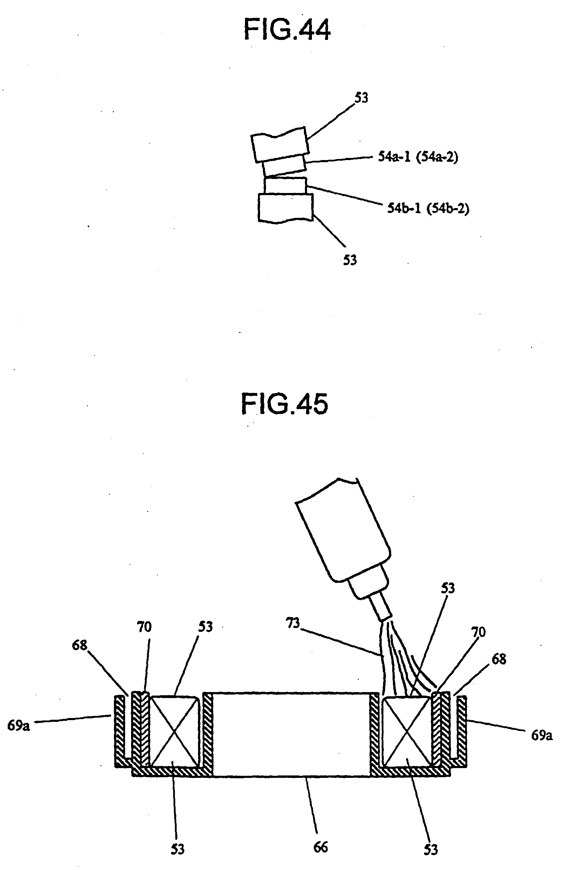

Thus, in the split type current transformer of the embodiment, the configuration of the nonmagnetic container 66 and magnetic circuit assembly 53 is maintained by the elastic force of the band elastic element 70 inserted in the gap of the nonmagnetic container 66 and magnetic circuit assembly 53 along the outer circumference of the magnetic circuit assembly 53. On the other hand, as shown in Fig. 43 or Fig. 44, deviation or inclination of the abutting surfaces of the magnetic element ends 54a-1 and 54b-1 or abutting surfaces of magnetic element ends 54a-2 and 54b-2 at the butt junctions 54c and 54d of the magnetic elements 54a and 54b can be easily corrected, regardless of the elastic force of the elastic element 70.

After correction of deviation or inclination above, while tightening with the band fixing element 57, as shown in Fig. 45, by filling and curing the remaining gap in the nonmagnetic container 66 with an elastic filler 73, the configuration after correction can be maintained. After curing of the filler 73, if the band fixing element 57 is loosened, the correct configuration is maintained by the filler 73. If a slight gap or inclination should occur in the abutting surfaces of the magnetic element ends 54a-1 and 54b-1 or abutting surfaces of the magnetic element ends 54a-2 and 54b-2, it is easy to join the surfaces tightly by tightening again by the band fixing element 57.

Thus, according to the split type current transformer of the embodiment, it is easy to assemble because the guide grooves of the band fixing element 57 are formed in the nonmagnetic container 66. Besides, the opening 54c can be opened more easily and widely, and if the band fixing element 57 is loosened, a correct configuration is maintained by the filler 73, and therefore the working efficiency in installation can be notably enhanced, and a high reliability is obtained.

(Embodiment 19)

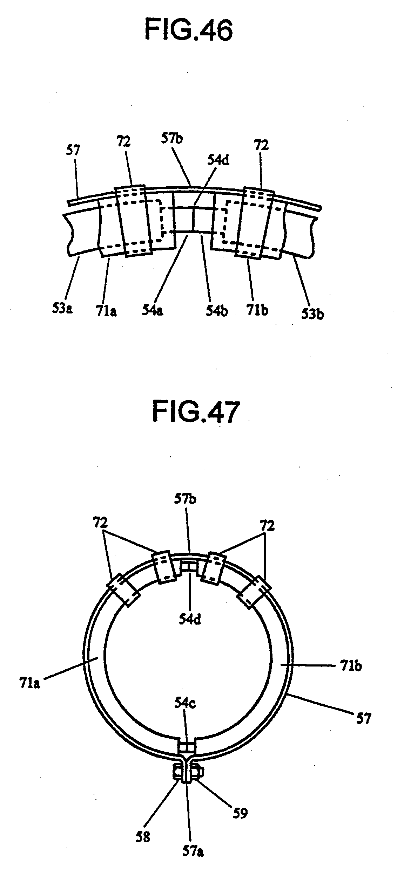

Fig. 46 and Fig. 47 show a further different embodiment of a current transformer of the invention. In Fig. 46 and Fig. 47, reference numerals 71a and 71b are nonmagnetic containers, 54a is one of the divided magnetic elements, and 54b is other divided magnetic element. This embodiment relates to a constitution of the nonmagnetic container 71 and the band fixing element 57 at the fulcrum near the butt junction 54d of the magnetic element 54a and magnetic element 54b.

In this embodiment, the magnetic elements 54a and 54b wound with the winding are accommodated in separate nonmagnetic containers 71a and 71b. In the embodiment, at the butt junction 54c side, it has the same structure as in embodiment 14 in Fig. 25, but at the butt junction 54d side, the magnetic element ends 54a-2 and 54b-2 project out of the nonmagnetic containers 71a and 71b, and are joined butt to butt outside of the nonmagnetic containers 71a and 71b.

With the magnetic elements 54a and 54b accommodated in separate nonmagnetic containers 71a and 71b held in the joined state at the two butt junctions 54c and 54d, the outer circumference of the nonmagnetic containers 71a and 71b is tightened by the band fixing element 57 made of an elastic material. The nonmagnetic containers 71a and 71b are fixed at plural positions each to the band fixing element 57 by means of a tape 72. The butt junction end 54c side of the magnetic elements 54a and 54b is an opening of the band fixing element 57, and the band fixing element 57 is clamped at its opening by means of screw 58 and nut 59.

According to this embodiment, since the band fixing element 57 is made of an elastic material, it is easy to open the opening 57a of the band fixing element 57 around the fulcrum 57b (that is, near the butt junction 54d), and the strength of the fulcrum can be assured. Also according to this embodiment, since the nonmagnetic containers 71a and 71b are not required to be made of elastic material, they can be made of easy-to-mold resin, and the wall thickness of the containers can be reduced, so that the split type current transformer may be further reduced in size.

**Claims**

1. A multicircuit type watt meter comprising:

   voltage input means for receiving and delivering plural voltages of an alternating-current electric power circuit,
   current input means for receiving and delivering current values in the same number of voltages supplied into said voltage input means or more,
   electric power measuring means in the same number of said current input means or more, and
   voltage-current combining means for arbitrarily selecting the voltage delivered from said voltage input means and feeding to said electric power measuring means.

2. A multicircuit type watt meter of claim 1, wherein the voltage-current combining means has changeover switches for receiving voltages from plural voltage input means and selecting only one of said voltage inputs, disposed by the same number as the number of said electric power measuring means.

3. A multicircuit type watthour meter comprising:

   voltage input means for receiving and delivering plural voltages of an alternating-current electric power circuit,
   current input means for receiving and delivering current values in the same number of voltages supplied into said voltage input means or more,
   electric energy measuring means in the same number of said current input means or more, and
   voltage-current combining means for arbitrarily selecting the voltage delivered from said voltage input means and feeding to said electric energy measuring means.

4. A multicircuit type watthour meter of claim 3, wherein the voltage-current combining means has changeover switches for receiving voltages from plural voltage input means and selecting only one of said voltage inputs, disposed by the same number as the number of said electric energy measuring means.

5. A multicircuit type watt meter comprising:

   voltage input means for receiving and delivering plural voltages of an alternating-current electric power circuit,
   voltage-current combining means composed of parts for arbitrarily selecting and delivering voltage values delivered from said voltage input means,
   current input means for receiving and delivering current values in the same number of voltages supplied into said voltage input means or more,
   current switching means for delivering current values delivered from said current input means one by one by time sharing, and
   electric power measuring means for measuring the electric power of the multiple circuits from the voltages entered from said voltage-current combining means and currents entered from said current switching means,
   wherein said electric power measuring means is composed of time shared measuring means for sampling the voltages entered from said voltage-current combining means and currents entered from said current switching means by time sharing, and measuring by converting the time shared sampled analog data into digital data, and an electric power computing section for measuring the electric power from said digital data of current and voltage delivered from said time shared measuring means.

6. A multicircuit type watthour meter comprising:

voltage input means for receiving and delivering plural voltages of an alternating-current electric power circuit,
voltage-current combining means composed of parts for arbitrarily selecting and delivering voltage values delivered from said voltage input means,
current input means for receiving and delivering current values in the same number of voltages supplied into said voltage input means or more,
current switching means for delivering current values delivered from said current input means one by one by time sharing, and
electric energy measuring means for measuring the electric energy of the multiple circuits from the voltages entered from said voltage-current combining means and currents entered from said current switching means,
wherein said electric energy measuring means is composed of time shared measuring means for sampling the voltages entered from said voltage-current combining means and currents entered from said current switching means by time sharing, and measuring by converting the time shared sampled analog data into digital data, and an electric energy computing section for measuring the electric energy from said digital data of current and voltage delivered from said time shared measuring means.

7. A multicircuit type watt meter comprising:

voltage input means for receiving and delivering voltages of plural lines of an alternating-current electric power circuit,
current input means for receiving and delivering currents in the same number of voltages to said voltage input means or more, and
an electric power measuring section,
wherein said electric power measuring section is composed of time shared measuring means for sampling the voltages entered from said voltage input means and currents entered from said current input means by time sharing, and measuring by converting the time shared sampled analog data into digital data, and an electric power computing section for storing the voltage digital data delivered from said time shared measuring means in a memory, combining said voltage digital data arbitrarily with current digital data delivered from said time shared measuring means, and measuring the electric power from said combined current digital data and voltage digital data.

8. A multicircuit type watthour meter comprising:

voltage input means for receiving and delivering voltages of plural lines of an alternating-current electric power circuit,
current input means for receiving and delivering currents in the same number of voltages to said voltage input means or more, and
an electric energy measuring section,
wherein said electric energy measuring section is composed of time shared measuring means for sampling the voltages entered from said voltage input means and currents entered from said current input means by time sharing, and measuring by converting the time shared sampled analog data into digital data, and an electric energy computing section for storing the voltage digital data delivered from said time shared measuring means in a memory, combining said voltage digital data arbitrarily with current digital data delivered from said time shared measuring means, and measuring the electric energy from said combined current digital data and voltage digital data.

9. A multicircuit type instrument comprising:

at least one line or more of voltage input means for receiving voltages of alternating-current three-phase electric circuit or alternating-current single-phase electric circuit,
current input means for receiving currents of said alternating-current three-phase electric circuit or said alternating-current single-phase electric circuit through current transformers in the same number of voltage input means or more,
current input switching means for switching over said current input means,
an A/D converter converting an analog output of said voltage input means into a voltage digital signal, and converting an analog output of said current input switching means into a current digital signal, and
a CPU for controlling switching of said current input switching means, controlling time shared multiplex sampling of the output of said A/D converter, and computing the electric power of all circuits connected through current transformers by said current input means from the data sampled simultaneously by time shared multiplex.

**10.** A multicircuit type instrument of claim 9, wherein said CPU computes the electric energy instead of said electric power.

**11.** A multicircuit type instrument of claim 9, wherein said CPU computes the power factor instead of said electric power.

**12.** A multicircuit type instrument of claim 9, wherein said CPU computes the reactive power instead of said electric power.

**13.** A multicircuit type instrument of claim 9, wherein said CPU computes the reactive energy instead of said electric power.

**14.** A multicircuit type instrument comprising:

at least one line or more of voltage input means for receiving voltages of alternating-current three-phase electric circuit or alternating-current single-phase electric circuit, current input means for receiving currents of said alternating-current three-phase electric circuit or alternating-current single-phase electric circuit through current transformers in the same number of voltage input means or more, voltage input switching means for switching over said voltage input means, current input switching means for switching over said current input means, an A/D converter converting an analog output of said voltage input switching means into a voltage digital signal, and converting an analog output of said current input switching means into a current digital signal, and a CPU for controlling switching of said voltage input switching means and current input switching means, controlling time shared multiplex sampling of the output of said A/D converter, and computing the electric power of all circuits connected through current transformers by said current input means from the data sampled simultaneously by time shared multiplex.

**15.** A multicircuit type instrument of claim 14, wherein said CPU computes the electric energy instead of said electric power.

**16.** A multicircuit type instrument of claim 14, wherein said CPU computes the power factor instead of said electric power.

**17.** A multicircuit type instrument of claim 14, wherein said CPU computes the reactive power instead of said electric power.

**18.** A multicircuit type instrument of claim 14, wherein said CPU computes the reactive energy instead of said electric power.

**19.** A multicircuit type instrument comprising:

at least one line or more of voltage input means for receiving voltages of alternating-current three-phase electric circuit or alternating-current single-phase electric circuit, current input switching means for switching over currents entered from said alternating-current three-phase electric circuit or alternating-current single-phase electric circuit through current transformers, at least one or more current input means for receiving outputs of said current input switching means, an A/D converter converting an analog output of said voltage input means into a voltage digital signal, and converting an analog output of said current input means into a current digital signal, and a CPU for controlling switching of said current input switching means, controlling time shared multiplex sampling of the output of said A/D converter, and computing the electric power of all circuits connected to said current input switching means through current transformers from the data sampled simultaneously by time shared multiplex.

**20.** A multicircuit type instrument of claim 19, wherein said CPU computes the electric energy instead of said electric power.

**21.** A multicircuit type instrument of claim 19, wherein said CPU computes the power factor instead of said electric power.

**22.** A multicircuit type instrument of claim 19, wherein said CPU computes the reactive power instead of said electric power.

**23.** A multicircuit type instrument of claim 19, wherein said CPU computes the reactive energy instead of said electric power.

**24.** A multicircuit type instrument comprising:

voltage input switching means for switching over voltage inputs of at least one line or more of alternating-current three-phase electric circuit or alternating-current single-phase electric circuit, current input switching means for switching over current inputs entered from said alternating-current three-phase electric circuit or said alternating-current single-phase electric circuit through current transformers in the same number as said voltage inputs or more,

at least one or more voltage input means for receiving outputs of said voltage input switching means,

at least one or more current input means for receiving outputs of said current input switching means,

an A/D converter converting an analog output of said voltage input means into a voltage digital signal, and converting an analog output of said current input means into a current digital signal, and

a CPU for controlling switching of said voltage input switching means and said current input switching means, controlling time shared multiplex sampling of the output of said A/D converter, and computing the electric power of all circuits connected to said current input switching means through current transformers from the data sampled simultaneously by time shared multiplex.

25. A multicircuit type instrument of claim 24, wherein said CPU computes the electric energy instead of said electric power.

26. A multicircuit type instrument of claim 24, wherein said CPU computes the power factor instead of said electric power.

27. A multicircuit type instrument of claim 24, wherein said CPU computes the reactive power instead of said electric power.

28. A multicircuit type instrument of claim 24, wherein said CPU computes the reactive energy instead of said electric power.

29. A multicircuit type instrument comprising:

voltage input means for receiving plural voltages of plural lines of alternating-current three-phase electric circuit or alternating-current single-phase electric circuit,

current input means for receiving plural currents of said plural lines of alternating-current three-phase electric circuit or alternating-current single-phase electric circuit,

a power source switching section for automatically selecting one line having voltage out of said plural lines of alternating-current three-phase electric circuit or alternating-current single-phase electric circuit connected through said voltage input means,

a power source section for using the voltage delivered from said power source switching section as the power source for the multicircuit type instrument, and

electric power measuring means for measuring the electric power from the output of said voltage input means and output of said current input means,

wherein it is designed to measure continuously the electric power of other circuit than the power failure line if power failure occurs in any alternating-current circuit of the plural lines.

30. A multicircuit type instrument of claim 29, wherein said electric power measuring means for measuring the electric power is replaced by electric energy measuring means for measuring the electric energy.

31. A multicircuit type instrument of claim 29, wherein said electric power measuring means for measuring the electric power is replaced by power factor measuring means for measuring the power factor.

32. A multicircuit type instrument of claim 29, wherein said electric power measuring means for measuring the electric power is replaced by reactive power measuring means for measuring the reactive power.

33. A multicircuit type instrument of claim 29, wherein said electric power measuring means for measuring the electric power is replaced by reactive energy measuring means for measuring the reactive energy.

34. A multicircuit type instrument comprising:

voltage input means for receiving plural voltages of plural lines of alternating-current three-phase electric circuit or alternating-current single-phase electric circuit,

current input means for receiving plural currents of said plural lines of alternating-current three-phase electric circuit or alternating-current single-phase electric circuit,

a power source switching section for automatically selecting one line having voltage out of said plural lines of alternating-current three-phase electric circuit or alternating-current single-phase electric circuit connected through said voltage input means,

priority order selecting means for specifying priority order in said plural lines of alternating-current three-phase electric circuit or alternating-current single-phase electric circuit, and issuing a command to said power source switching means so that said power source switching means may select the line having voltage according to the priority order,

a power source section for using the voltage delivered from said power source switching section as the power source for the multicircuit type instrument, and

electric power measuring means for measuring the electric power from the output of said voltage input means and output of said current input means,

wherein it is designed to measure continuously the electric power of other circuit than the power failure line if power failure occurs in any alternating-current circuit of the plural lines.

35. A multicircuit type instrument of claim 34, wherein said electric power measuring means for measuring the electric power is replaced by electric energy measuring means for measuring the electric energy.

36. A multicircuit type instrument of claim 34, wherein said electric power measuring means for measuring the electric power is replaced by power factor measuring means for measuring the power factor.

37. A multicircuit type instrument of claim 34, wherein said electric power measuring means for measuring the electric power is replaced by reactive power measuring means for measuring the reactive power.

38. A multicircuit type instrument of claim 34, wherein said electric power measuring means for measuring the electric power is replaced by reactive energy measuring means for measuring the reactive energy.

39. A split type current transformer comprising:

a magnetic circuit assembly having one magnetic element for composing a closed circuit divided into two sections, applying a winding conforming to the current transformer rating around each one of the two divided magnetic elements, connecting one end of two windings to the additional polarity, and using other end of two windings as secondary output terminal of current transformer,

a nonmagnetic container enveloping the entire circumference of said magnetic circuit assembly, having an opening near the divided end of the magnetic element closer to said secondary output terminal, and deforming at the position remotest from said opening to be used as a fulcrum, and

a fixing element for tightening the outer circumference of said nonmagnetic container for fixing the magnetic circuit assembly divided into two sections.

40. A split type current transformer of claim 39, wherein the opening is made open by the deformation of the nonmagnetic container by elongating at its fulcrum.

41. A split type current transformer of claim 39, wherein the deformation by elongation is made easy by forming a V-shaped notch at the inner side of the fulcrum of the nonmagnetic container.

42. A split type current transformer of claim 39, wherein the outer circumference of the nonmagnetic container is tightened by one band fixing element so that the split surfaces of the two divided magnetic elements may tightly contact with each other.

43. A split type current transformer of claim 39, wherein the nonmagnetic element is fabricated by resin molding, a linkage part of $\Omega$-shape or inverted U-shape is provided at the outer side of the fulcrum, so that the opening may be made open widely by deforming easily at the fulcrum, and an elastic element is fitted in the gap between said nonmagnetic container and said magnetic circuit assembly.

44. A split type current transformer comprising:

a magnetic circuit assembly having one magnetic element for composing a closed circuit divided into two sections, applying a winding conforming to the current transformer rating around each one of the two divided magnetic elements, connecting one end of two windings to the additional polarity, and using other end of two windings as secondary output terminal of current transformer,

a nonmagnetic container enveloping the entire circumference of said magnetic circuit assembly, having an opening near the divided end of the magnetic element closer to said secondary output terminal, forming a fulcrum at the remotest position from said opening in an $\Omega$-shape or inverted U-shape in the outer circumferential direction, and forming a guide groove at the inner circumferential side of said fulcrum in $\Omega$-shape or inverted U-shape, and

a band fixing element being made of a material capable of tightening the outer circumference of a nonmagnetic containers formed so that the split surfaces of the two magnetic elements may tightly contact with each other, and having an elasticity so as to be opened at said secondary output terminal side of said winding, being fitted into said guide groove provided in said nonmagnetic container.

45. A split type current transformer of claim 44, wherein an elastic element is fitted in the gap between said nonmagnetic container and said magnetic circuit assembly.

**46.** A split type current transformer of claim 44, wherein said guide groove is a U-shaped groove, and a plurality of grooves consisting of groove opening upward and groove opening downward are provided.

**47.** A split type current transformer of claim 44, wherein after tightening by the band fixing element, the positioning of the butt junctions of magnetic elements is corrected, and the gap in the nonmagnetic container is filled with an elastic filler.

**48.** A split type current transformer comprising:

a magnetic circuit assembly having one magnetic element for composing a closed circuit divided into two sections, applying a winding conforming to the current transformer rating around each one of the two divided magnetic elements, connecting one end of two windings to the additional polarity, and using other end of two windings as secondary output terminal of current transformer,
two independent nonmagnetic containers enveloping said magnetic circuit assembly together with said divided magnetic elements, divided to as to be opened at the butt junctions of the magnetic elements,
a band fixing element being made of a material capable of tightening the outer circumference of two nonmagnetic containers combined so that the split surfaces of the two magnetic elements may tightly contact with each other, and having an elasticity so as to be opened at said secondary output terminal side of said winding.

# FIG.1

EP 0 961 124 A2

# FIG.2

# FIG.3

# FIG.4

# FIG.5

# FIG.6

100    LINE VOLTAGE      200    CIRCUIT CURRENT

VOLTAGE INPUT MEANS      CURRENT INPUT MEANS

400        500

VOLT.-CUR. CONBING MEANS      CURRENT SWITCHING MEANS

610

6111    SAMPLING & HOLD SECTION

611

6112    ANALOG/DIGITAL CONVERTER

6121    COMPUTING SECTION

612

6122    MEMORY

# FIG.7

# FIG.8

332

3321

3323

3322

3321a — CIRCUIT I ELECTRIC POWER COMPUTING SECTION $p1=i1\times vk1$

3321b — CIRCUIT II ELECTRIC POWER COMPUTING SECTION $p2=i2\times vk2$

3321c — CIRCUIT III ELECTRIC POWER COMPUTING SECTION $p3=i3\times vk3$

3321d — CIRCUIT IV ELECTRIC POWER COMPUTING SECTION $p4=i4\times vk4$

3321e — CIRCUIT V ELECTRIC POWER COMPUTING SECTION $p5=i5\times vk5$

3321f — CIRCUIT VI ELECTRIC POWER COMPUTING SECTION $p6=i6\times vk6$

Vk1 ~ Vk6 VOLTAGE MEMORY AREA SET UP SECTION

3322a — LINE I VOLTAGE TIME SHARED DATA

3322b — LINE II VOLTAGE TIME SHARED DATA

3322c — LINE III VOLTAGE TIME SHARED DATA

# FIG.9

100  LINE VOLTAGE        200  CIRCUIT CURRENT

| VOLTAGE INPUT MEANS | CURRENT INPUT MEANS |

6311 — SAMPLING & HOLD SECTION

6312 — ANALOG/DIGITAL CONVERTER

630

631

6321 — COMPUTING SECTION

632

6322 — MEMORY

# FIG.10

632
6321
6322
6323

6321a — CIRCUIT I ELECTRIC ENERGY COMPUTING SECTION
$e1 = \int (i1 \times vk1)$

6321b — CIRCUIT II ELECTRIC ENERGY COMPUTING SECTION
$e2 = \int (i2 \times vk2)$

6321c — CIRCUIT III ELECTRIC ENERGY COMPUTING SECTION
$e3 = \int (i3 \times vk3)$

6321d — CIRCUIT IV ELECTRIC ENERGY COMPUTING SECTION
$e4 = \int (i4 \times vk4)$

6321e — CIRCUIT V ELECTRIC ENERGY COMPUTING SECTION
$e5 = \int (i5 \times vk5)$

6321f — CIRCUIT VI ELECTRIC ENERGY CALCULATING SECTION
$e6 = \int (i6 \times vk6)$

Vk1 ~ Vk6 VOLTAGE MEMORY AREA SET UP SECTION

6322a — LINE I VOLTAGE TIME SHARED DATA

6322b — LINE II VOLTAGE TIME SHARED DATA

6322c — LINE III VOLTAGE TIME SHARED DATA

## FIG.11

LINE I VOLTAGE

LINE II VOLTAGE

LINE III VOLTAGE

} A

· CIRCUIT I CURRENT

CIRCUIT II CURRENT

CIRCUIT III CURRENT

CIRCUIT IV CURRENT

CIRCUIT V CURRENT

CIRCUIT VI CURRENT

} B

## FIG.12

LINE I VOLTAGE

LINE II VOLTAGE

LINE III VOLTAGE

} A

CIRCUIT I CURRENT

CIRCUIT II CURRENT

CIRCUIT III CURRENT

CIRCUIT IV CURRENT

CIRCUIT V CURRENT

CIRCUIT VI CURRENT

} B

# FIG.13

# FIG.14 A

# FIG.14 B

FIG.15

# FIG.16

# FIG.17

EP 0 961 124 A2

# FIG.18

LINE 1

R  S  T

32a

33a

LOAD

LINE 2

R  S  T

32b

33b

LOAD

15

2200a

2500

**VOLTAGE INPUT MEANS I**

**CURRENT INPUT MEANS I**

2300a

2400

**POWER SOURCE**

2600

2200b

**VOLTAGE INPUT MEANS II**

**CURRENT INPUT MEANS II**

2300b

**WATT-HOUR COMPUTING MEANS**

Multicircuit-type Watt-hour Met

# FIG.19

# FIG.20

LINE 1

R   S   T

2200a

17

2900

I VOLTAGE INPUT MEANS

I CURRENT INPUT MEANS

32a

33a

LOAD

2300a

2800   2400   2700

POWER SOURCE

PRIORITY ORDER SELECTING MEANS

LINE 2

R   S   T

2200b

II VOLTAGE INPUT MEANS

II CURRENT INPUT MEANS

32b

33b

LOAD

2300b

WATT-HOUR COMPUTING MEANS

LINE 3

R   S   T

2200c

III VOLTAGE INPUT MEANS

III CURRENT INPUT MEANS

32c

33c

LOAD

2300c

Multicircuit-type Watt-hour Meter

52

# FIG.21

# FIG.22

# FIG.23

# FIG.24

# FIG.25

# FIG.26

# FIG.27

# FIG.28

# FIG.29

56

# FIG.30

54d (54a-2, 54b-2)

56

53

53

56-1

54a-1, 54b-1

m1

n1

54c (54a-1, 54b-1)

# FIG.31

56

55a
(55b)

54a
(54b)

## FIG.32

## FIG.33

# FIG.34

# FIG.35

# FIG.36

54a
62
54b-1
62
54b

54a-1
63

# FIG.37

65
64
54a
54b
54d

# FIG.38

# FIG.39

# FIG.40

# FIG.41

# FIG.42

# FIG.43

# FIG.44

# FIG.45

# FIG.46

# FIG.47

EP 0 961 124 A2

# FIG.48

# FIG.49

67